(19)

Europäisches
Patentamt
European
Patent Office
Office européen
des brevets

(11) **EP 4 395 508 A1**

(12) **EUROPEAN PATENT APPLICATION**

(43) Date of publication:
**03.07.2024 Bulletin 2024/27**

(21) Application number: **23218549.6**

(22) Date of filing: **20.12.2023**

(51) International Patent Classification (IPC):
**H10K 59/122** (2023.01)

(52) Cooperative Patent Classification (CPC):
**H10K 59/122**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.12.2022 KR 20220190845**

(71) Applicant: **LG Display Co., Ltd.**
**Seoul 07336 (KR)**

(72) Inventors:
• YEO, Kyungmin
**10845 Paju-si, Gyeonggi-do, (KR)**
• CHOI, Suk
**10845 Paju-si, Gyeonggi-do, (KR)**

(74) Representative: **Viering, Jentschura & Partner
mbB**
**Patent- und Rechtsanwälte**
**Am Brauhaus 8**
**01099 Dresden (DE)**

(54) **ORGANIC LIGHT-EMITTING DISPLAY DEVICE**

(57)      The organic light-emitting display device (100) comprises a substrate (110) having a folding axis extending in a first direction (D1), the substrate (110) including a folding area (FA1, FA2) configured to curve around the folding axis in a second direction (D2) intersecting the first direction (D1); a first anode (132A) on the substrate (110); a bank layer (140) on the substrate (110); and a plurality of first spacers (S1) provided on the bank layer (140) in the folding area (FA1, FA2) and disposed in the second direction (D2). The plurality of first spacers (S1) comprises a first-first spacer (142a1) extending in a direction deviating from the first direction (D1) and the second direction (D2) when viewed in a plan view; and a first-second spacer (142a2) spaced apart from the first-first spacer (142a1) in the second direction (D2) and extending in a direction parallel to the direction in which the first-first spacer (142a1) extends. The first-first spacer and the first-second spacer (142a2) at least partially overlap each other when viewed in the plan view.

FIG. 4

EP 4 395 508 A1

**Description**

**CROSS-REFERENCE TO RELATED APPLICATION**

This application claims the priority of Republic of Korea Patent Application No. 2022-0190845 filed on December 30, 2022.

**BACKGROUND**

**Field**

The present disclosure relates to an organic light-emitting display device, and more particularly, to an organic light-emitting element that is inhibited from being separated and cracked when the organic light-emitting element is folded, the organic light-emitting display device being more robust against stress when the organic light-emitting display device is folded.

**Description of the Related Art**

An organic light-emitting display (OLED) device does not require a separate light source, unlike a liquid crystal display (LCD) device having a backlight. The advantages of the organic light-emitting display device are that the organic light-emitting display device may be manufactured to be lightweight and thin, a process may be facilitated, and power consumption is low because the organic light-emitting display device may be operated by a low voltage. Among other things, the organic light-emitting display device may have an autonomous light-emitting element, and layers of the organic light-emitting display device may be configured by thin organic films. The advantages of the organic light-emitting display device are that the organic light-emitting display device may have excellent flexibility and elasticity in comparison with other display devices and thus be implemented as a foldable display device.

In general, an organic light-emitting display panel of a foldable display device has a substrate, an anode, a bank layer, a light-emitting layer, a cathode, and a sealing layer and has a spacer on the bank layer. In this case, there is a problem in that high stress is applied to the spacer when the organic light-emitting display device is folded. In case that high stress is applied to the spacer as described above, there occur problems in that another organic light-emitting element may be cracked, and the so-called moire occurs which forms a wavy pattern on the spacer. The moire may more often occur particularly on a bar-shaped spacer having an inversely tapered structure.

**SUMMARY**

An object to be achieved by the present disclosure is to provide an organic light-emitting display device that suppresses or minimizes the occurrence of moire on a spacer by reducing stress applied to the spacer when the organic light-emitting display device is folded.

Another object to be achieved by the present disclosure is to provide an organic light-emitting display device that inhibits a spacer and another organic light-emitting element from being cracked and separated when the organic light-emitting display device is folded, the organic light-emitting display device being capable of displaying higher-quality images by suppressing or minimizing the occurrence of moire on the spacer.

In particular, the moire mainly occurs on a bar-type spacer having an inversely tapered structure. Therefore, still another object to be achieved by the present disclosure is to provide an organic light-emitting display device that suppresses the occurrence of moire on a spacer having an inversely tapered structure by reducing stress applied to a spacer when the organic light-emitting display device is folded.

Objects of the present disclosure are not limited to the above-mentioned objects, and other objects, which are not mentioned above, can be clearly understood by those skilled in the art from the following descriptions. According to an aspect of the present disclosure, an organic light-emitting display device according to claim 1 is provided. Further embodiments are described in the dependent claims.

According to an aspect of the present disclosure, an organic light-emitting display device includes: a substrate having a folding axis extending in a first direction, the substrate including a folding area configured to be curved to surround the folding axis in a second direction that intersects the first direction while the substrate is folded, a first anode on the substrate, a bank layer on the substrate that exposes a central portion of the first anode, and a plurality of first spacers arranged on the bank layer in the folding area along the second direction, wherein the plurality of first spacers comprises: a first-first spacer extending in a direction that is different from the first direction and the second direction when viewed in a plan view of the substrate; and a first-second spacer spaced apart from the first-first spacer in the second direction and extending in a direction parallel to the direction in which the first-first spacer extends, wherein the first-first spacer and the first-second spacer at least partially overlap each other when viewed in a direction parallel to the first direction.

According to an aspect of the present disclosure, an organic light-emitting display device includes: a substrate having a folding axis extending in a first direction, the substrate including a folding area configured to curve around the folding axis in a second direction that intersects the first direction while the substrate is folded, a transistor on the substrate, a first anode on connected to the transistor, a bank layer on a portion of the first anode, a light emitting part on the first anode, a cathode on the light emitting part and the bank layer, a first spacer on the bank layer and at a first side of the first anode, the first spacer extending in a third direction that is different from the first direction and the second direction in a plan view of the substrate, a second spacer on the bank layer at the first side of the first anode and spaced apart from the first spacer in the second direction, the second spacer extending in the third direction, and a sealing part on the cathode, at least a portion of the sealing part in contact with a side surface of the first spacer and a side surface of the second spacer, wherein at least a portion of the first spacer and a portion of the second spacer overlap in the first direction.

Other detailed matters of the exemplary embodiments are included in the detailed description and the drawings.

According to the present disclosure, it is possible to suppress or minimize the moire occurring on the spacer by reducing stress applied to the spacer when the organic light-emitting display device is folded.

According to the present disclosure, it is possible to reduce stress applied to the panel when the organic light-emitting display device is folded, thereby inhibiting the organic light-emitting element from being cracked and separated.

The effects according to the present disclosure are not limited to the contents exemplified above, and more various effects are included in the present specification.

## BRIEF DESCRIPTION OF THE DRAWINGS

The above and other aspects, features and other advantages of the present disclosure will be more clearly understood from the following detailed description taken in conjunction with the accompanying drawings, in which:

FIG. 1 is a schematic top plan view illustrating an unfolded state of an organic light-emitting display device according to an exemplary embodiment of the present disclosure;

FIG. 2 is a schematic perspective view illustrating a folded state in which the organic light-emitting display device in FIG. 1 is folded about a folding area according to an exemplary embodiment of the present disclosure;

FIG. 3 is a schematic cross-sectional view illustrating a cross-section of a subpixel SP taken along line I-I' of FIG. 1 according to an exemplary embodiment of the present disclosure;

FIG. 4 is a view illustrating one example of a schematic enlarged top plan view of area A in FIG. 1 according to an exemplary embodiment of the present disclosure;

FIG. 5 is a view illustrating one example of a schematic enlarged top plan view of area A in FIG. 1 or an area at the periphery of area A according to an exemplary embodiment of the present disclosure;

FIG. 6 is a view illustrating another example of a schematic enlarged top plan view of area A in FIG. 1 and an area at the periphery of area A according to an exemplary embodiment of the present disclosure;

FIG. 7 is a view illustrating still another example of a schematic enlarged top plan view of area A in FIG. 1 and an area at the periphery of area A according to an exemplary embodiment of the present disclosure;

FIG. 8 is a view illustrating yet another example of a schematic enlarged top plan view of area A in FIG. 1 and an area at the periphery of area A according to an exemplary embodiment of the present disclosure;

FIG. 9 is a view illustrating still yet another example of a schematic enlarged top plan view of area A in FIG. 1 or an area at the periphery of area A according to an exemplary embodiment of the present disclosure;

FIG. 10 is a view illustrating still yet another example of a schematic enlarged top plan view of area A in FIG. 1 and an area at the periphery of area A according to an exemplary embodiment of the present disclosure;

FIG. 11 is a view illustrating still another further example of a schematic enlarged top plan view of area A in FIG. 1 and an area at the periphery of area A according to an exemplary embodiment of the present disclosure; and

FIG. 12 is a view illustrating one example of a schematic enlarged top plan view of area B in FIG. 4 according to an exemplary embodiment of the present disclosure.

## DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

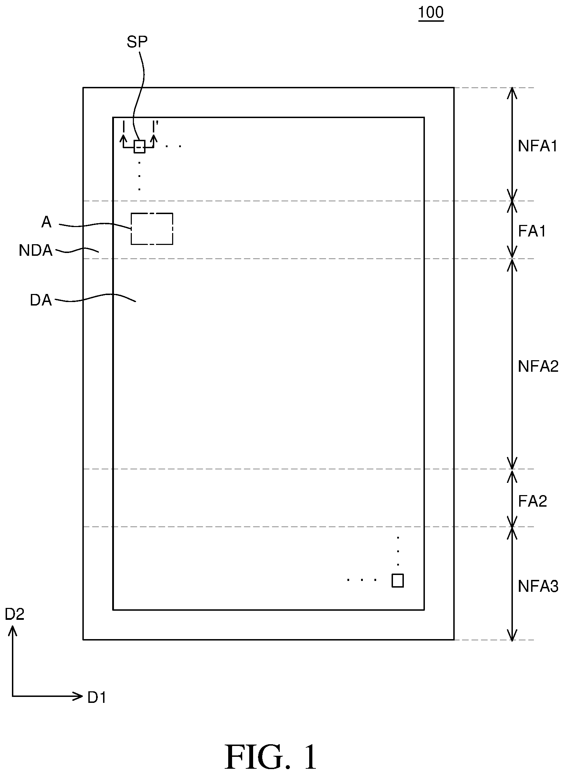

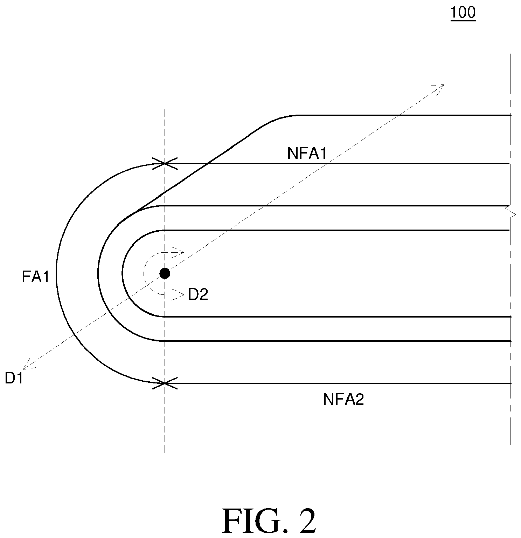

FIG. 1 is a schematic top plan view illustrating an unfolded state of an organic light-emitting display device according to an exemplary embodiment of the present disclosure, and FIG. 2 is a schematic perspective view illustrating a folded state in which the organic light-emitting display device in FIG. 1 is folded about a folding area.

Referring to FIG. 1, an organic light-emitting display device 100 according to an exemplary embodiment of the present disclosure includes a display area DA and a non-display area NDA. The display area DA is an area in which the plurality of subpixels SP is disposed to substantially display images. The subpixel SP including a light-emitting area for displaying an image may be disposed in the display area DA. A drive circuit for operating the subpixel SP may be disposed in the display area DA. The plurality of subpixels SP is arranged in a matrix shape. The subpixel SP is an element for displaying one color and includes the light-emitting area in which light is emitted, and a non-light-emitting area in which no light is emitted. The non-display area NDA surrounds the display area DA. The non-display area NDA is an area in which no image is substantially displayed. Various lines, drive ICs, printed circuit boards, and the like for operating pixels and drive circuits disposed in the display area DA are disposed in the non-display area NDA. For example, various ICs, such as a gate driver IC and a data driver IC, VSS lines, and the like may be disposed in the non-display area NDA.

The plurality of subpixels SP constitutes a single pixel. For example, the single pixel may include a first subpixel (not illustrated), a second subpixel (not illustrated), and a third subpixel (not illustrated). The pixels including the first subpixels (not illustrated), the second subpixels (not illustrated), and the third subpixels (not illustrated) may be arranged in a matrix shape. However, the present disclosure is not limited thereto. The first subpixel (not illustrated), the second subpixel (not illustrated), and the third subpixel (not illustrated) may display different colors. For example, the first subpixel (not illustrated) may display a red color, the second subpixel (not illustrated) may display a green color, and the third subpixel (not illustrated) may display a blue color. However, the present disclosure is not limited thereto.

With reference to FIGS. 1 and 2, a substrate includes at least one folding area capable of being folded, and a non-folding area that is an area excluding the folding area. FIGS. 1 and 2 exemplarily illustrate that the folding area includes a first folding area FA1 and a second folding area FA2, and thus the non-folding area includes a first non-folding area NFA1, a second non-folding area NFA2, and a third non-folding area NFA3. However, the present disclosure is not limited thereto.

The folding areas FA1 and FA2 are areas that are folded when the organic light-emitting display device 100 is folded. The folding areas FA1 and FA2 may be folded about folding axes along particular radii of curvature. For example, folding axes of the folding areas FA1 and FA2 may be defined in an X-axis direction. The non-folding areas NFA1, NFA2, and NFA3 may extend from the folding areas FA1 and FA2 in a Y-axis direction perpendicular to the folding axes. In case that the folding areas FA1 and FA2 are folded about the folding axes, the folding areas FA1 and FA2 may each define a part of a circle or ellipse. In this case, the radii of curvature of the folding areas FA1 and FA2 may each mean a radius of a circle or ellipse defined by each of the folding areas FA1 and FA2.

That is, the folding axis may extend in the X-axis direction or first direction D1. The organic light-emitting display device 100 may have a plurality of folding axes and thus have the folding areas FA1 and FA2 respectively corresponding to the folding axes. The folding areas FA1 and FA2 may be curved to surround the corresponding folding axes. A direction in which each of the folding areas FA1 and FA2 is curved to surround the folding axis may be the Y-axis direction or a second direction D2. The second direction may mean a direction may be identical to the Y-axis direction or mean a direction intersecting the first direction.

The non-folding areas NFA1, NFA2, and NFA3 are areas that are not folded when the organic light-emitting display device 100 is folded. That is, the non-folding areas NFA1, NFA2, and NFA3 are each kept in a flat state when the organic light-emitting display device 100 is folded. The non-folding areas NFA1, NFA2, and NFA3 may each be positioned at two opposite sides of each of the folding areas. That is, the non-folding areas NFA1, NFA2, and NFA3 may each be an area extending in the Y-axis direction (or second direction) based on the folding axis. In this case, the folding areas FA1 and FA2 may be defined between the non-folding areas NFA1, NFA2, and NFA3. In addition, the non-folding areas NFA1, NFA2, and NFA3 may overlap one another when the organic light-emitting display device 100 is folded about the folding axes.

For example, the first folding area FA1 may be defined between the first non-folding area NFA1 and the second non-folding area NFA2, and the second folding area FA2 may be defined between the second non-folding area NFA2 and the third non-folding area NFA3.

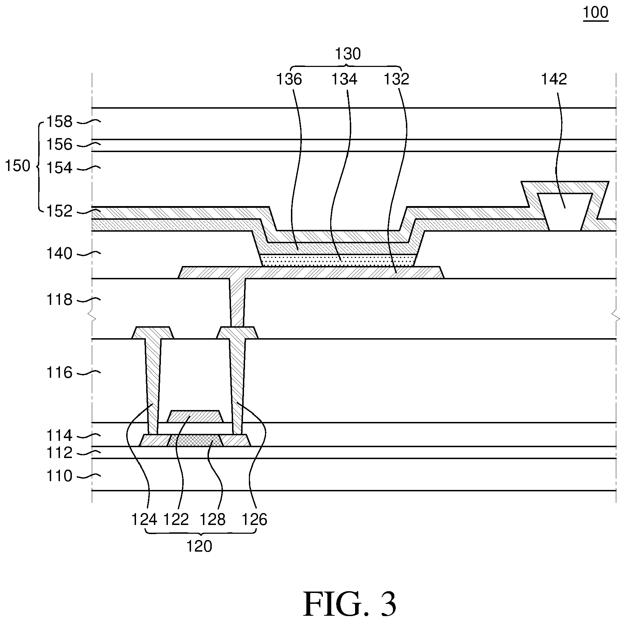

Because the organic light-emitting display device 100 includes a substrate 110 (see FIG. 3) to be described below, it can be said that the substrate 110 to be described below has the display area DA and the non-display area NDA that have been described above. In addition, it can be said that the substrate 110 to be described below has the folding areas FA1 and FA2 and the non-folding areas NFA1, NFA2, and NFA3. Hereinafter, for convenience, the configuration will be described in which the substrate 110 has the display area DA and the non-display area NDA and has the folding areas FA1 and FA2 and the non-folding areas NFA1, NFA2, and NFA3.

FIG. 3 is a schematic cross-sectional view illustrating a cross-section of a subpixel SP taken along line I-I' of FIG. 1 according to an exemplary embodiment of the present disclosure.

With reference to FIG. 3, the substrate 110 serves to support and protect the constituent elements of the organic light-emitting display device 100 that are disposed on an upper portion of the substrate 110. Recently, because the substrate 110 may be made of a ductile material having flexibility, the substrate 110 may be a flexible substrate. For example, the flexible substrate may be provided in the form of a film made of one selected from a group comprising of polyester-based polymer, silicon-based polymer, acrylic polymer, polyolefin-based polymer, and a copolymer thereof.

For example, the flexible substrate 110 may be made of at least one of polyethylene terephthalate (PET), polybutylene terephthalate (PBT), polysilane, polysiloxane, polysilazane, polycarbosilane, polyacrylate, polymethacrylate, polymethylacrylate, polymethylmetacrylate, polyethylacrylate, polyethylmetacrylate, cyclic olefin copolymer (COC), cyclic olefin polymer (COP), polyethylene (PE), polypropylene (PP), polyimide (PI), polymethylmethacrylate (PMMA), polystyrene (PS), polyacetal (POM), polyether ether ketone (PEEK), polyester sulfone (PES), polytetrafluoroethylene (PTFE), polyvinyl chloride (PVC), polycarbonate (PC), polyvinylidene fluoride (PVDF), perfluoroalkyl polymer (PFA), styrene acrylic nitrile copolymer (SAN), and combinations thereof.

A buffer layer 112 is disposed on the flexible substrate 110. The buffer layer 112, which is configured as a single layer or multilayer made of silicon oxide (SiOx) or silicon nitride (SiNx) may suppress the penetration of moisture or other impurities through the substrate 110 and planarize a surface of the substrate 110. The buffer layer 112 is not a necessarily necessary component. The buffer layer 112 may be excluded depending on the type of substrate 110 or the type of thin-film transistor disposed on the substrate 110.

A thin-film transistor 120 disposed on the buffer layer 112 includes a gate electrode 122, a source electrode 124, a drain electrode 126, and a semiconductor layer 128.

The semiconductor layer 128 may be made of amorphous silicon. Alternatively, the semiconductor layer 128 may be made of polycrystalline silicon that has better mobility and reliability and requires lower energy power consumption than amorphous silicon and thus may be applied to a driving thin-film transistor in the pixel. However, the present disclosure is not limited thereto.

Recently, an oxide semiconductor has been in the limelight because of excellent mobility and uniformity thereof. The oxide semiconductor may be made of materials based on indium-tin-gallium-zinc oxide (InSnGaZnO) which is quaternary metal oxide, materials based on indium-gallium-zinc oxide (InGaZnO), indium-tin-zinc oxide (InSnZnO), indium-aluminum-zinc oxide (InAlZnO), tin-gallium-zinc oxide (SnGaZnO), aluminum-gallium-zinc oxide (AlGaZnO), and tin-aluminum-zinc oxide (SnAlZnO) which are ternary metal oxide, materials based on indium-zinc oxide (InZnO), tin-zinc oxide (SnZnO), aluminum-zinc oxide (AlZnO), zinc-magnesium oxide (ZnMgO), tin-magnesium oxide (SnMgO), indium-magnesium oxide (InMgO), and indium-gallium oxide (InGaO) which are binary metal oxide, and materials based on indium oxide (InO), tin oxide (SnO), and zinc oxide (ZnO). The present disclosure is not limited to a composition ratio of the respective elements.

The semiconductor layer 128 may include source and drain areas including p-type or n-type impurities, and a channel between the source and drain areas. The semiconductor layer 128 may include a low concentration doping area disposed between the source and drain areas adjacent to the channel.

The semiconductor layer 128 may include an area doped with one impurity among boron (B), aluminum (Al), gallium (Ga), and indium (In). The semiconductor layer 128 may include an area doped with one high-concentration impurity among phosphorus (P), arsenic (As), and antimony (Sb).

A first insulation layer 114 is an insulation layer configured as a single layer or multilayer made of silicon oxide (SiOx) or silicon nitride (SiNx). The first insulation layer 114 is disposed such that an electric current flowing in the semiconductor layer 128 does not flow to the gate electrode 122. Further, the silicon oxide has lower flexibility than metal but has higher flexibility than silicon nitride. The silicon oxide may be selectively implemented as a single layer or multilayer in accordance with properties thereof.

Further, in case that the polycrystalline silicon is applied to the semiconductor layer 128, the insulation layer disposed adjacent to the semiconductor layer 128 may constitute an inorganic film layer with a high hydrogen particle content. For example, a layer adjacent to the semiconductor layer 128 made of polycrystalline silicon is made of silicon nitride (SiNx), and a layer, which is not adjacent to the semiconductor layer 128, is made of silicon oxide (SiOx), such that hydrogen particles are stabilized while being diffused to the semiconductor layer 128 made of polycrystalline silicon, which may suppress the deterioration in properties of the thin-film transistor 120.

Further, in case that the oxide semiconductor is applied to the semiconductor layer 128, an insulation layer disposed adjacent to the semiconductor layer 128 may constitute an inorganic film layer with a low hydrogen content. For example, a layer adjacent the semiconductor layer 128 made of an oxide is made of silicon oxide (SiOx), and a layer, which is not adjacent the semiconductor layer 128, is made of silicon nitride (SiNx), which may suppress the deterioration in properties of the thin-film transistor 120 by inhibiting the hydrogen particles from being diffused to the semiconductor layer 128.

The gate electrode 122 may serve as a switch configured to turn on or off the thin-film transistor 120 based on an electrical signal transmitted from the outside through the gate line. The gate electrode 122 may be configured as a single layer or multilayer made of a conductive metallic material such as copper (Cu), aluminum (Al), molybdenum (Mo), chromium (Cr), gold (Au), titanium (Ti), nickel (Ni), neodymium (Nd), or an alloy thereof. However, the present disclosure is not limited thereto.

The source electrode 124 and the drain electrode 126 may be connected to the data line and allow the electrical signal transmitted from the outside to be transmitted from the thin-film transistor 120 to a light-emitting element 130. The source electrode 124 and the drain electrode 126 may each be configured as a single layer or multilayer made of a conductive metallic material such as copper (Cu), aluminum (Al), molybdenum (Mo), chromium (Cr), gold (Au), titanium (Ti), nickel (Ni), neodymium (Nd), or an alloy thereof. However, the present disclosure is not limited thereto.

A second insulation layer 116 made of silicon oxide (SiOx) or silicon nitride (SiNx) may be disposed between the gate electrode 122, the source electrode 124, and the drain electrode 126 in order to insulate the gate electrode 122, the source electrode 124, and the drain electrode 126 from one another.

A passivation layer may be further disposed on the thin-film transistor 120 and configured as an inorganic insulation layer made of silicon oxide (SiOx), silicon nitride (SiNx), or the like. The passivation layer may serve to suppress unnecessary electrical connection between the constituent elements disposed on upper and lower portions of the passivation layer. The passivation layer may also serve to suppress damage or contamination from the outside. The passivation layer may be excluded in accordance with the configurations and properties of the thin-film transistor 120 and the light-emitting element 130.

The structures of the thin-film transistor 120 may be classified into an inverted staggered structure and a coplanar structure depending on the positions of the constituent elements that constitute the thin-film transistor 120. In the thin-film transistor having the inverted staggered structure, the gate electrode is positioned at a side opposite to the source electrode and the drain electrode based on the semiconductor layer. In the thin-film transistor 120 having the coplanar structure, the gate electrode 122 is provided at the same side as the source electrode 124 and the drain electrode 126 based on the semiconductor layer 128.

FIG. 3 illustrates the thin-film transistor 120 having the coplanar structure. However, the organic light-emitting display device 100 may include the thin-film transistor having the inverted staggered structure.

For convenience of description, only a driving thin-film transistor is illustrated among various thin-film transistors that may be included in the organic light-emitting display device 100. However, a switching thin-film transistor, a capacitor, and the like may be included in the organic light-emitting display device 100. Further, when a signal is applied from the gate line, the switching thin-film transistor transmits the signal from the data line to the gate electrode of the driving thin-film transistor. In response to a signal received from the switching thin-film transistor, the driving thin-film transistor transmits an electric current, which is transmitted through the power line, to an anode. The driving thin-film transistor controls light emission on the basis of the electric current transmitted to the anode.

A planarization layer 118 is disposed on the thin-film transistor 120 to protect the thin-film transistor 120, reduce a level difference caused by the thin-film transistor 120, and reduce parasitic capacitance occurring between the thin-film transistor 120, the gate line, the data line, and the light-emitting element 130.

Further, the planarization layer 118 may be formed as a plurality of layers in accordance with structures and properties of the organic light-emitting display device 100. The planarization layer 118 may be made of one or more materials among acrylic resin, epoxy resin, phenolic resin, polyamide-based resin, polyimide-based resin, unsaturated polyester-based resin, polyphenylene-based resin, polyphenylene sulfide-based resin, and benzocyclobutene. However, the present disclosure is not limited thereto.

The light-emitting element 130 disposed on the planarization layer 118 includes an anode 132, a light-emitting part 134, and a cathode 136.

The anode 132 disposed on the planarization layer 118 may be made of indium tin oxide (ITO), indium zinc oxide (IZO), or the like that is a transparent electrically conductive material. However, the present disclosure is not limited thereto. For convenience of description, the anode 132 may be described as being disposed on the substrate 110 because the anode 132 is disposed on the planarization layer 118.

In case that the organic light-emitting display device 100 is a top emission type that emits light toward an upper side at which the cathode 136 is disposed, the organic light-emitting display device 100 may further include a reflective layer so that the emitted light may be reflected by the anode 132 and more smoothly discharged to the upper side at which the cathode 136 is disposed.

For example, the anode 132 may have a two-layer structure in which a reflective layer and a transparent conductive layer made of a transparent electrically conductive material are sequentially stacked. Alternatively, the anode 132 may have a three-layer structure in which the transparent conductive layer, the reflective layer, and the transparent conductive layer are sequentially stacked. The reflective layer may be made of an alloy containing silver (Ag).

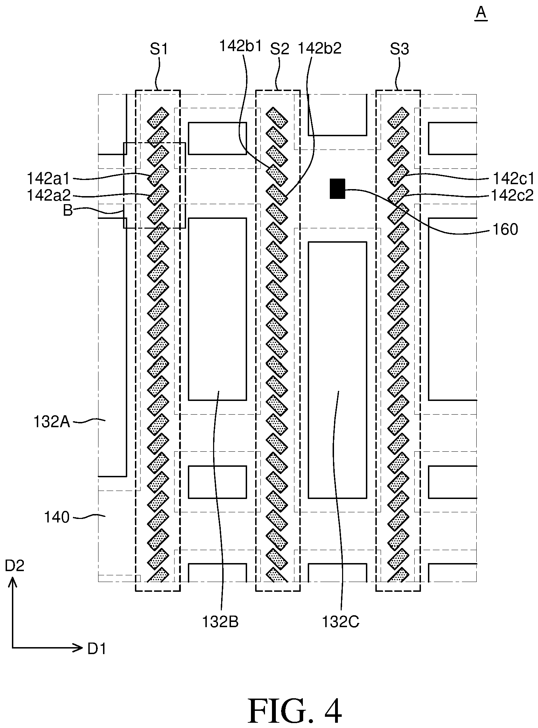

The anode 132 may include a plurality of anodes 132A, 132B, and 132C (see FIG. 4) corresponding to the plurality of subpixels. The plurality of anodes 132A, 132B, and 132C will be described below.

The pixels, by which areas for actually emitting light may be partitioned, are defined by a bank layer 140 disposed on the anode 132 and the planarization layer 118. That is, the bank layer 140 may be disposed on the planarization layer 118 and at least expose a central portion of a top surface of the anode. The bank layer 140 may include at least one opening portion to at least expose the central portion of the top surface of the anode. In addition, for convenience of description, the bank layer 140 may be described as being disposed on the substrate 110 because the bank layer 140 is disposed on the planarization layer 118.

The bank layer 140 may be formed by performing photolithography after forming a photoresist. The photoresist refers to photosensitive resin having solubility that is changed with respect to a developer by the action of light. A particular pattern may be obtained by exposing and developing the photoresist.

The photoresists may be classified into a positive photoresist and a negative photoresist. The positive photoresist refers to a photoresist in which solubility of an exposed part in respect to a developer is increased by exposure. When the positive photoresist is developed, a pattern from which the exposed part is removed is obtained. Further, the negative photoresist refers to a photoresist in which solubility of an exposed part in respect to a developer is decreased by exposure. When the negative photoresist is developed, a pattern from which a non-exposed part is removed is obtained.

A fine metal mask (FMM), which is a deposition mask, may be used to form the light-emitting part 134 of the organic light-emitting display device 100. Further, a spacer 142 is disposed on the bank layer 140 to inhibit damage caused by contact with the deposition mask disposed on the bank layer 140 and maintain a predetermined distance between the bank layer 140 and the deposition mask.

The spacer 142 may be made of the same material as the bank layer 140 and formed by one process. In the folding area in which the flexible organic light-emitting display device 100 is folded, the spacer 142 is formed and disposed on the bank layer 140 in an area adjacent to the light-emitting element 130 in order to suppress the separation caused by the folding.

The spacer 142 may be configured as a spacer having an inversely tapered shape having a width that increases upward. That is a width of the spacer increases in a direction away from the substrate 110. At a point at which the spacer 142 having an inversely tapered shape adjoins the bank layer 140, the light-emitting element 130 is not deposited on a side surface of the spacer 142, such that the continuity is broken. However, because a sealing part 150 is formed on an upper portion, the light-emitting part may be fixed by being bonded to a side surface of the spacer 142. A portion of the sealing part 150 (e.g., sealing layer 152) may be in contact with a side surface of the spacer 142. Therefore, it is possible to increase a bonding force and suppress the separation of the light-emitting element 130 disposed in the folding area in which the flexible organic light-emitting display device 100 is folded.

In the present specification, an inversely tapered shape and an inversely tapered structure may have the same meaning, and the inversely tapered shape or the inversely tapered structure based on a shape of a cross-section of the spacer.

For example, FIG. 3 illustrates a spacer 142 having the inversely tapered structure. However, the present specification is not limited thereto. The spacer 142 may have an inversely tapered multilayer structure having two or more layers.

Therefore, a bonding area of the sealing part 150 bonded onto the spacer 142 may be maximized, which may implement a higher bonding force than when a single inversely tapered structure is provided.

The spacer 142 may be formed by forming the bank layer 140, depositing a negative photoresist material, and forming a dual inversely tapered structure by using one half-tone mask. The negative photoresist refers to a photoresist in which solubility of an exposed part with respect to a developer is decreased by exposure. The dual inversely tapered structure may be formed by removing a non-exposed part by developing the negative photoresist.

The spacer 142 may at least include a plurality of first to third spacers S1, S2, and S3 (see FIG. 4) disposed in a second direction D2 on the bank layer 140 of each of the folding areas FA1 and FA2. The plurality of first to third spacers S1, S2, and S3 will be described below.

The light-emitting part 134 is disposed between the anode 132 and the cathode 136. The light-emitting part 134 serves to emit light. The light-emitting part 134 may include at least one of a hole injection layer (HIL), a hole transport layer (HTL), a light-emitting layer, an electron transport layer (ETL), and an electron injection layer (EIL). Some constituent elements of the light-emitting part 134 may be excluded depending on the structures or properties of the organic light-emitting display device 100. In this case, an organic light-emitting layer and an inorganic light-emitting layer may be applied as the light-emitting layer.

The hole injection layer is disposed on the anode 132 and serves to facilitate the injection of the positive holes. For example, the hole injection layer may be made of any one or more of HAT-CN (dipyrazino[2,3-f:2',3'-h]quinoxaline-2,3,6,7,10.11-hexacarbonitrile), CuPc (phthalocyanine), and NPD (N,N'-bis (naphthalene-1-yl)-N,N'-bis (phenyl)-2,2'-dimethylbenzidine).

The hole transport layer is disposed on the hole injection layer and serves to smoothly transmit the positive holes to the light-emitting layer. For example, the hole transport layer may be made of any one or more of NPD (N,N'-bis (naphthalene-1-yl)-N,N'-bis (phenyl)-2,2'-dimethylbenzidine), TPD (N,N'-bis-(3-methylphenyl)-N,N'-bis-(phenyl)-benzidine), s-TAD (2,2',7,7'-tetrakis (N,N-dimethylamino)-9,9-spirofluorene), and MTDATA (4,4',4"-Tris (N-3-methylphenyl-N-phenyl-amino)-triphenylamine).

The light-emitting layer is disposed on the hole transport layer. The light-emitting layer may be made of a material capable of emitting light with a particular color, thereby emitting the light with the particular color. Further, a phosphorescent material or a fluorescent material may be used as the light-emitting material.

In case that the light-emitting layer emits light with a red color, a peak wavelength of the emitted light may be within a range of 600 nm to 650 nm. The light-emitting layer may be made of a phosphorescent material including a material including CBP (4,4'-bis (carbazol-9-yl) biphenyl) or mCP (1,3-bis (carbazol-9-yl) benzene) and including a dopant including one or more of PIQIr (acac) (bis (1-phenylisoquinoline) (acetylacetonate) iridium), PQIr (acac) (bis (1-phenylquinoline) (acetylacetonate) iridium), PQIr (tris (1-phenylquinoline) iridium), and PtOEP (octaethylporphyrin platinum). Alternatively, the light-emitting layer may be made of a fluorescent material including PBD:Eu (DBM) 3 (Phen) or Perylene.

In this case, the peak wavelength ($\lambda$ is electroluminescence (EL)) refers to a maximum wavelength. A wavelength of inherent light emitted by the light-emitting layers constituting the light-emitting part is referred to as photoluminescence (PL), and light emitted under the influence of thicknesses or optical characteristics of the layers constituting the light-emitting layers is referred to as emittance. In this case, the electroluminescence (EL) is referred to as light finally emitted by the electroluminescent display device and may be expressed as the product of the photoluminescence (PL) and the emittance.

In case that the light-emitting layer emits light with a green color, the peak wavelength of the emitted light may be within a range of 520 nm to 540 nm. The light-emitting layer may be made of a phosphorescent material including a host material including CBP or mCP and including a dopant material such as Ir complex including Ir (ppy) 3 (tris (2-phenylpyridine) iridium). In addition, the light-emitting layer may be made of a fluorescent material including Alq3 (tris (8-hydroxyquinolino) aluminum).

In case that the light-emitting layer emits light with a blue color, the peak wavelength of the emitted light may be within a range of 440 nm to 480 nm. The light-emitting layer may be made of a phosphorescent material including a host material including CBP or mCP and including a dopant material including FIrPic (bis (3,5-difluoro-2-(2-pyridyl) phenyl-(2-carboxypyridyl) iridium). In addition, the light-emitting layer may be made of a fluorescent material including any one of spiro-DPVBi (4,4'-Bis (2,2-diphenyl-ethen-1-yl) biphenyl), DSA (1-4-di-[4-(N,N-di-phenyl) amino]styryl-benzene), polyfluorene (PFO)-based polymer, and polyphenylenevinylene (PPV)-based polymer.

The electron transport layer is disposed on the light-emitting layer to smoothly move electrons to the light-emitting layer. For example, the electron transport layer may be made of any one or more of Liq (8-hydroxyquinolinolato-lithium), PBD (2-(4-biphenyl)-5-(4-tert-butylphenyl)-1,3,4-oxadiazole), TAZ (3-(4-biphenyl) 4-phenyl-5-tert-butylphenyl-1,2,4-triazole), spiro-PBD, BCP (2,9-Dimethyl-4,7-diphenyl-1,10-phenanthroline), and BAlq (bis(2-methyl-8-quinolinolate)-4-(phenylphenolato) aluminum).

An electron injection layer may be further disposed on the electron transport layer. The electron injection layer is an organic layer that facilitates the injection of electrons from the cathode 136. The electron injection layer may be eliminated depending on the structure and properties of the organic light-emitting display device 100. The electron injection layer may be made of a metal inorganic compound such as $BaF_2$, LiF, NaCl, CsF, $Li_2O$, and BaO or any one or more organic compounds among HAT-CN (dipyrazino[2, 3-f:2',3'-h]quinoxaline-2,3,6,7,10.11-hexacarbonitrile), CuPc (phthalocyanine), and NPD (N,N'-bis(naphthalene-1-yl)-N,N'-bis(phenyl)-2,2'-dimethylbenzidine).

An electron blocking layer for blocking a flow of electrons or a hole blocking layer for blocking a flow of positive holes is further disposed at a position adjacent to the light-emitting layer. Therefore, it is possible to inhibit the electron from moving from the light-emitting layer and passing through the adjacent hole transport layer when the electrons are injected into the light-emitting layer or inhibit the positive hole from moving from the light-emitting layer and passing through the adjacent electron transport layer when the positive holes are injected into the light-emitting layer, thereby improving luminous efficiency.

The cathode 136 is disposed on the light-emitting part 134 and serves to supply the electrons to the light-emitting part 134. The cathode 136 needs to supply electrons. Therefore, the cathode 136 may be made of a metallic material such as magnesium (Mg), a silver-magnesium alloy (Ag:Mg), or the like that is an electrically conductive material having a low work function. However, the present disclosure is not limited thereto.

In case that the organic light-emitting display device 100 is a top-emission type, the cathode 136 may be made of transparent conductive oxide such as indium tin oxide (ITO), indium zinc oxide (IZO), indium-tin-zinc oxide (ITZO), zinc oxide (ZnO), and tin oxide (TiO).

The sealing part 150 is disposed on the light-emitting element 130 and inhibits the thin-film transistor 120 and the light-emitting element 130, which are the constituent elements of the organic light-emitting display device 100, from being oxidized or damaged by moisture, oxygen, or impurities introduced from the outside.

The sealing part 150 may be formed by stacking a plurality of sealing layers 152 and 156, a particle compensation layer 154, and a plurality of barrier films 158.

A first sealing layer 152 may be disposed on the entire upper portions of the thin-film transistor 120 and the light-emitting element 130 and made of one of silicon nitride (SiNx) or aluminum oxide (AlyOz) that is an inorganic material. However, the present disclosure is not limited thereto. A second sealing layer 156 may be further disposed on the particle compensation layer 154 disposed on the first sealing layer 152. The first sealing layer 152 may be formed by a process such as atomic layer deposition ALD. However, the present disclosure is not limited thereto.

In one embodiment, the first sealing layer 152 is in contact with the side surface of the first spacer and the side surface of the spacer and is in contact with an upper surface of the first spacer and an upper surface of the second spacer. The first sealing layer 152 may be bonded (e.g., in contact with) a side surface of the second spacer having inversely tapered structures and fix the light-emitting element 130 to increase the bonding force and suppress the separation of the light-emitting element 130 disposed in the folding area in which the flexible organic light-emitting display device 100 is folded.

The particle compensation layer 154 may be disposed on the first sealing layer 152 and made of silicon oxycarbon (SiOCz), acrylic, or epoxy-based resin that is an organic material. However, the present disclosure is not limited thereto. When a defect occurs because of cracks caused by foreign substances or particles that may be produced during the process, the particle compensation layer 154 may cover and compensate for unevenness and foreign substances.

A barrier film 158 may be disposed on the sealing layers 152 and 156 and the particle compensation layer 154 and delay the penetration of oxygen and moisture from the outside of the organic light-emitting display device 100. The barrier film 158 may be provided in the form of a film having light transmissivity and double-sided bondability and made of any one insulating material among an olefin-based insulating material, an acrylic-based insulating material, and a silicon-based insulating material. Alternatively, a barrier film made of any one material among cyclolefin polymer (COP), cycloolefin copolymer (COC), and polycarbonate (PC). However, the present disclosure is not limited thereto.

The organic light-emitting display device 100 according to the exemplary embodiment of the present specification includes the flexible substrate including the display area including the pixels and the non-display area disposed at the outer periphery of the display area, the thin-film transistor disposed in the folding area and the display area in which the flexible substrate in the display area is folded, the bank layer disposed on the thin-film transistor and configured to partition the pixels, the light-emitting element disposed adjacent to the bank layer, the one or more spacers disposed on the bank layer and each having the inversely tapered structure, and the sealing part disposed on the light-emitting element, the first spacer, and the second spacer.

FIG. 4 is a view illustrating one example of a schematic enlarged top plan view of area A in FIG. 1 according to an exemplary embodiment of the present disclosure.

With reference to FIGS. 3 and 4 together, the organic light-emitting display device 100 according to the exemplary embodiment of the present specification may include the substrate 110, a first anode 132A, a second anode 132B, the bank layer 140, a sealing part 150, and a plurality of first spacers S1.

The substrate 110 may include the folding area having the folding axis extending in a first direction D1, and the folding area configured to be curved to surround the folding axis in the second direction D2 intersecting the first direction D1. The first anode 132A may be disposed on the substrate 110, and the bank layer 140 may be disposed on the substrate 110 to at least expose a central portion of the first anode 132A. That is, the bank layer 140 may cover an edge of the first anode 132A. The second anode 132B may be disposed on the substrate 110 and spaced apart from the first anode 132A in the first direction D1.

With reference to FIG. 4, the plurality of first spacers S1 may be provided on the bank layer 140 in the folding area and disposed in the second direction D2. The plurality of first spacers S1 may be disposed between the first anode 132A and the second anode 132B.

A length of each of the plurality of first spacers S1 may extend in a direction deviating from the first direction D1 and the second direction D2 when viewed in a direction perpendicular to the substrate 110. That is, the length of the plurality of first spacers S1 may extend in a third direction that is different from the first direction D1 and the second direction D2 when viewed in a plan view of the display device 100. The direction in which the plurality of first spacers S1 each extends may be different from the first direction D1 and the second direction D2.

The plurality of first spacers S1 may at least include first-first spacers 142a1 and first-second spacers 142a2. In the present specification, for convenience of description, two spacers will be described among the plurality of spacers. However, the plurality of spacers of the present specification may, of course, include a larger number of spacers.

The first-first spacer 142a1 and the first-second spacer 142a2 may extend in the direction deviating from the first direction D1 and the second direction D2 (e.g., the third direction) when viewed in the direction perpendicular to the substrate 110. That is, the first-second spacer 142a2 may be spaced apart from the first-first spacer 142a1 in the second direction D2 and extend in a direction parallel to the direction in which the first-first spacer 142a1 extends. In addition, the other spacers included in the plurality of first spacers S1 may also be spaced apart from the first-first spacer 142a1 and the first-second spacer 142a2 in the second direction D2 and extend in the direction parallel to the direction in which the first-first spacer 142a1 and the first-second spacer 142a2 extend. For reference, in the present specification, the direction in which the spacer extends may mean a direction in which a major axis of the spacer is directed when viewed in the direction perpendicular to the substrate 110.

The first-first spacer 142a1 and the first-second spacer 142a2 may at least partially overlap each other when viewed in the direction parallel to the first direction D1. That is, a part of the first-second spacer 142a2 may be covered by or overlap the first-first spacer 142a1 when viewed in the direction parallel to the first direction D1.

In case that the first-first spacer 142a1 and the first-second spacer 142a2 at least partially overlap each other when viewed in the direction parallel to the first direction D1 as described above, the moire may be suppressed or minimized even though the folding operation is performed in the second direction D2. In addition, in case that the first-first spacer 142a1 and the first-second spacer 142a2 at least partially overlap each other, a stable structure may be implemented to the extent implemented by a bar-shaped spacer in the related art. In addition, in case that an appropriate overlap area is defined as the first-first spacer 142a1 and the first-second spacer 142a2 at least partially overlap each other, an area of the overlap area M is appropriately defined, such that the bonding force for the organic layer (e.g., the light emitting part 134) is increased, and the separation of the organic layer is effectively suppressed when the foldable display is folded.

Specifically, in case that the plurality of first spacers S1 is disposed to partially overlap one another while having a shape extending in the direction deviating from the first direction D1 and the second direction D2, a total area in which the spacers of the present disclosure are in contact with the organic layer is greatly increased in comparison with the bar-shaped spacer in the related art. As the contact area between the spacer and the organic layer increases, the bonding force with respect to the organic layer may be greatly increased, thereby suppressing the separation or cracks when the foldable display is folded.

Likewise, in addition to the first-first spacer 142a1 and the first-second spacer 142a2, the other spacers, among the plurality of first spacers S1, may at least partially overlap the adjacent spacers when viewed in the direction parallel to the first direction D1.

The plurality of first spacers S1 may each have the inversely tapered structure, as described above with reference to FIG. 3.

With reference to FIG. 4, the organic light-emitting display device 100 according to the exemplary embodiment of the present specification may further include a plurality of second spacers S2 provided on the bank layer 140 in the folding area and disposed in the second direction D2. The plurality of second spacers S2 may be spaced apart from the plurality of first spacers S1 in the first direction D1.

The plurality of second spacers S2 may be spaced apart from the second anode 132B in the first direction D1. That is, the plurality of second spacers S2 may be spaced apart from the second anode 132B in a direction opposite to the direction from the second anode 132B toward the first anode 132A. In other words, the second anode 132B may be disposed between the plurality of first spacers S1 and the plurality of second spacers S2.

The plurality of second spacers S2 may each extend in a direction deviating from the first direction D1 and the second direction D2 when viewed in the direction perpendicular to the substrate 110. That is, the length of the plurality of second spacers S2 may extend in the fourth direction that is different from the first direction D1, the second direction S2, and the third direction when viewed in the plan view of the display device 100. The direction in which the plurality of second spacers S2 each extends may be different from the first direction D1 and the second direction D2. In one embodiment, the plurality of first spacers S1 and the plurality of second spacers S2 are symmetrical across a center line of the second anode 132B that extends in the second direction D2.

The plurality of second spacers S2 may at least include second-first spacers 142b1 and second-second spacers 142b2. In the present specification, for convenience of description, two spacers will be described among the plurality of spacers. However, the plurality of spacers of the present specification may, of course, include a larger number of spacers.

The second-first spacer 142b1 and the second-second spacer 142b2 may extend in the direction (e.g., fourth direction) deviating from the first direction D1 and the second direction D2 when viewed in the direction perpendicular to the substrate 110. That is, the second-second spacer 142b2 may be spaced apart from the second-first spacer 142b1 in the second direction D2 and extend in the direction parallel to the direction in which the second-first spacer 142b1 extends. In addition, the other spacers included in the plurality of second spacers S2 may also be spaced apart from the second-first spacer 142b1 and the second-second spacer 142b2 in the second direction D2 and extend in the direction parallel to the direction in which the second-first spacer 142b1 and the second-second spacer 142b2 extend.

The plurality of second spacers S2 may each extend in a direction intersecting the direction in which the plurality of first spacers S1 each extends. That is, the direction in which the plurality of second spacers S2 each extends may be different from the direction in which the plurality of first spacers S1 each extends.

The second-first spacer 142b1 and the second-second spacer 142b2 may at least partially overlap each other when viewed in the direction parallel to the first direction D1. That is, a part of the second-second spacer 142b2 may be covered by or overlap the second-first spacer 142b1 when viewed in the direction parallel to the first direction D1.

In case that the second-first spacer 142b1 and the second-second spacer 142b2 at least partially overlap each other when viewed in the direction parallel to the first direction D1 as described above, the moire may be suppressed or minimized even though the folding operation is performed in the second direction D2. In addition, in case that the second-first spacer 142b1 and the second-second spacer 142b2 at least partially overlap each other, a stable structure may be implemented to the extent implemented by the bar-shaped spacer in the related art. In addition, in case that an appropriate overlap area is defined as the second-first spacer 142b1 and the second-second spacer 142b2 at least partially overlap each other, an area of the overlap area M is appropriately defined, such that the bonding force for the organic layer is increased, and the separation of the organic layer is effectively suppressed when the foldable display is folded.

Likewise, in addition to the second-first spacer 142b 1 and the second-second spacer 142b2, the other spacers, among the plurality of second spacers S2, may at least partially overlap the adjacent spacers when viewed in the direction parallel to the first direction D1.

The plurality of second spacers S2 may each have the inversely tapered structure, as described above with reference to FIG. 3.

With reference to FIG. 4, the organic light-emitting display device 100 according to the exemplary embodiment of the present specification may further include a third anode 132C and a plurality of third spacers S3.

The third anode 132C may be disposed on the substrate 110 and spaced apart from the second anode 132B in a direction opposite to the direction from the second anode 132B toward the first anode 132A.

The plurality of third spacers S3 may be provided on the bank layer 140, disposed in the second direction D2, and spaced apart from the plurality of second spacers S2 in the first direction D1. That is, the plurality of third spacers S3 may be spaced apart from the plurality of second spacers S2 in the direction opposite to the direction from the plurality of second spacers S2 toward the plurality of first spacers S1. In other words, the third anode 132C may be disposed between the plurality of second spacers S2 and the plurality of third spacers S3.

The plurality of third spacers S3 may each extend in a direction deviating from the first direction D1 and the second direction D2 when viewed in the direction perpendicular to the substrate 110. That is, the length of the plurality of third spacers S3 may extend in the third direction that is different from the first direction D1 and the second direction D2 when viewed in the plan view of the display device 100. The direction in which the plurality of second spacers S2 each extends may be different from the first direction D1 and the second direction D2. In one embodiment, the plurality of second spacers S2 and the plurality of third spacers S3 are symmetrical across a center line of the third anodes 132C that extends in the second direction D2.

The plurality of third spacers S3 may at least include third-first spacers 142c1 and third-second spacers 142c2. In the present specification, for convenience of description, two spacers will be described among the plurality of spacers. However, the plurality of spacers of the present specification may, of course, include a larger number of spacers.

The third-first spacer 142c1 and the third-second spacer 142c2 may extend in the direction deviating from the first direction D1 and the second direction D2 when viewed in the direction perpendicular to the substrate 110. That is, the third-second spacer 142c2 may be spaced apart from the third-first spacer 142c1 in the second direction D2 and extend in the direction parallel to the direction in which the third-first spacer 142c1 extends. In addition, the other spacers included in the plurality of third spacers S3 may also be spaced apart from the third-first spacer 142c1 and the third-second spacer 142c2 in the second direction D2 and extend in the direction parallel to the direction in which the third-first spacer 142c1 and the third-second spacer 142c2 extend.

The plurality of third spacers S3 may each extend in a direction intersecting the direction in which the plurality of second spacers S2 each extends. That is, the direction in which the plurality of third spacers S3 each extends may be different from the direction in which the plurality of second spacers S2 each extends. The direction in which the plurality of third spacers S3 each extends may be identical to the direction in which the plurality of first spacers S1 each extends.

The third-first spacer 142c1 and the third-second spacer 142c2 may at least partially overlap each other when viewed in the direction parallel to the first direction D1. That is, a part of the third-second spacer 142c2 may be covered by or overlap the third-first spacer 142c1 when viewed in the direction parallel to the first direction D1.

In case that the third-first spacer 142c1 and the third-second spacer 142c2 at least partially overlap each other when viewed in the direction parallel to the first direction D1 as described above, the moire may be suppressed or minimized even though the folding operation is performed in the second direction D2. In addition, in case that the third-first spacer 142c1 and the third-second spacer 142c2 at least partially overlap each other, a stable structure may be implemented to the extent implemented by the bar-shaped spacer in the related art. In addition, in case that an appropriate overlap area is defined as the third-first spacer 142c1 and the third-second spacer 142c2 at least partially overlap each other, an area of the overlap area M is appropriately defined, such that the bonding force for the organic layer is increased, and the separation of the organic layer is effectively suppressed when the foldable display is folded.

Likewise, in addition to the third-first spacer 142c1 and the third-second spacer 142c2, the other spacers, among the plurality of third spacers S3, may at least partially overlap the adjacent spacers when viewed in the direction parallel to the first direction D1.

The plurality of third spacers S3 may each have the inversely tapered structure, as described above with reference to FIG. 3.

With reference to FIG. 4, the organic light-emitting display device 100 may further include an auxiliary spacer 160 disposed on the bank layer 140 and spaced apart from the third anode 132C in the second direction D2. The auxiliary spacer 160 may be disposed between the plurality of second spacers S2 and the plurality of third spacers S3. The auxiliary spacer 160 may be provided in the form of a dot when viewed in the direction perpendicular to the substrate 110. Thus, the auxiliary spacer 160 has a different shape and is oriented in a different direction from the first, second, and third spacers S1, S2, and S3. In some instances, the auxiliary spacer 160 may also have the inversely tapered structure, as described above with reference to FIG. 3.

The organic light-emitting display device 100 may include a plurality of auxiliary spacers, and the auxiliary spacer 160 may be disposed between the anodes. The auxiliary spacer 160 may be disposed between the anodes disposed at relatively large intervals. Therefore, the organic light-emitting display device 100 may have the spacers provided more densely. As a result, the bonding force for the organic layer is increased, and the separation of the organic layer is effectively suppressed when the foldable display is folded.

Meanwhile, the auxiliary spacer 160 may be used to support a fine metal mask (FMM) that is a deposition mask used to form the organic light-emitting layer. The auxiliary spacer 160 may be used to maintain a predetermined distance from the deposition mask. The auxiliary spacer 160 may maintain predetermined distances between the deposition mask and the bank layer 140 and the anode 132, thereby suppressing damage caused by the contact. In this case, the auxiliary spacer 160 may have a shape having a width that decreases upward, i.e., have a tapered shape, for example, in order to minimize an area in which the auxiliary spacer 160 is in contact with the deposition mask. Meanwhile, FIG. 4 illustrates that the auxiliary spacer 160 has a quadrangular shape in a plan view. However, the present disclosure is not limited thereto.

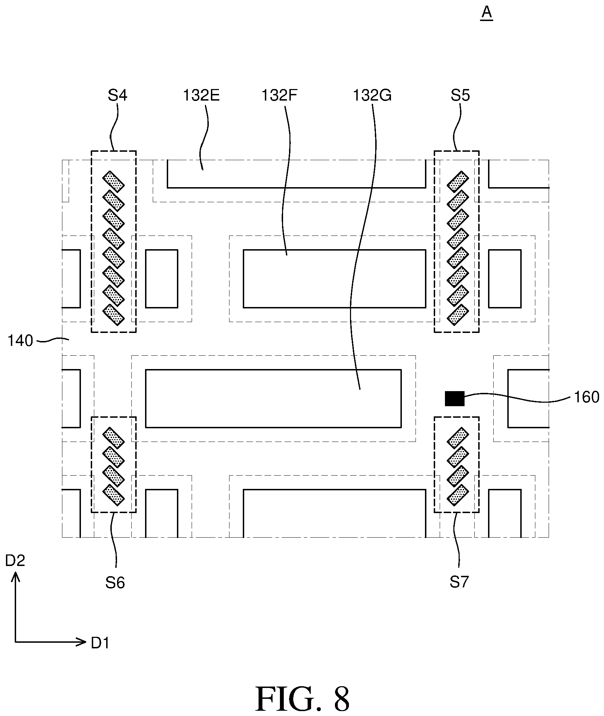

The anodes in FIG. 4 may each have a minor axis (e.g., a width) in a direction parallel to the first direction D1, and a major axis (e.g., a length) in a direction parallel to the second direction D2. The anodes in FIG. 4 differ from anodes in FIGS. 8 to 11 to be described below in that the anodes are folded in a direction of the major axis.

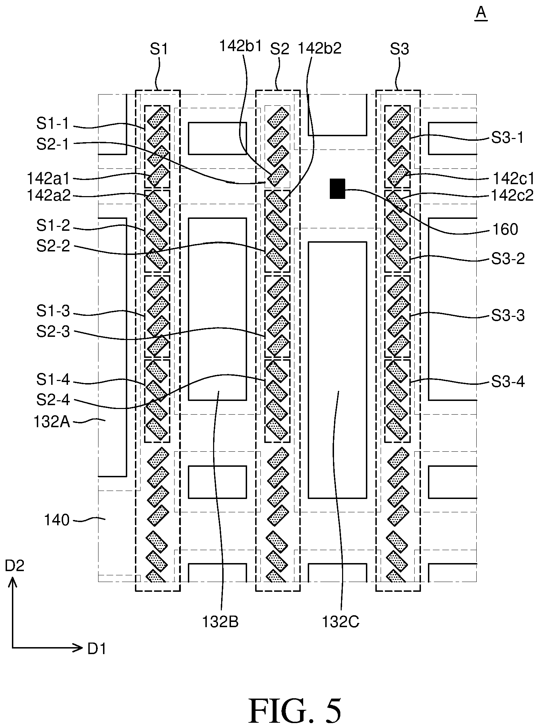

FIG. 5 is a view illustrating one example of a schematic enlarged top plan view of area A in FIG. 1 or an area at the periphery of area A according to an exemplary embodiment of the present disclosure.

The example illustrated in FIG. 5 may be substituted for the example illustrated in FIG. 4 or present at the periphery of the example illustrated in FIG. 4. For reference, the description of the configurations identical to or duplicative of those described above with reference to FIG. 5 may be omitted.

With reference to FIG. 5, the plurality of first spacers S1 may include a plurality of spacer groups when viewed in the direction perpendicular to the substrate 110. The plurality of spacer groups may each be defined by spacers extending in the same direction and disposed adjacent to one another.

The plurality of spacer groups included in the plurality of first spacers S1 may at least include a first-first spacer group S1-1 including the first-first spacer 142a1, and a first-second spacer group S1-2 including the first-second spacer 142a2 spaced apart from the first-first spacer group S1-1 in the second direction D2.

A length of each of the spacers of the first-first spacer group S1-1 may extend in the direction deviating from the first direction D1 and the second direction D2 when viewed in the direction perpendicular to the substrate 110. That is, a length of each of the spacers of the first-first spacer group S1-1 may extend in the third direction that is different from the first direction D1 and the second direction D2 when viewed in a plan view of the display device 100. The direction in which the spacers of the first-first spacer group S1-1 may be different from the first direction D1 and the second direction D2.

A length of each of the spacers of the first-second spacer group S1-2 may extend in the direction deviating from the first direction D1 and the second direction D2 when viewed in the direction perpendicular to the substrate 110. That is, a length of each of the spacers of the first-second spacer group S1-2 may extend in the fourth direction that is different from the first direction D1, the second direction S2, and the third direction when viewed in the plan view of the display device 100. The direction in which the spacers of the first-second spacer group S1-2 extend may intersect or, in some instances, be orthogonal to the direction in which the spacers of the first-first spacer group S1-1 extend.

The spacers of the first-first spacer group S1-1 and the spacers of the first-second spacer group S1-2 may not overlap one another when viewed in the direction parallel to the first direction D1.

When the spacer groups, in which the spacers extend in different directions, overlap each other as described above, the spacer disposed at an outermost end may be cracked because of a collision between the different groups during the folding operation.

The plurality of spacer groups included in the plurality of first spacers S1 may further include a first-third spacer group S1-3. The first-third spacer group S1-3 may be spaced apart from the first-second spacer group S1-2 in the second direction D2. The first-third spacer group S1-3 may be spaced apart from the first-second spacer group S1-2 in a direction opposite to a direction from the first-second spacer group S1-2 toward the first-first spacer group S1-1.

A length of each of the spacers of the first-third spacer group S1-3 may extend in the direction deviating from the first direction D1 and the second direction D2 when viewed in the direction perpendicular to the substrate 110 (e.g., the third direction). The direction in which the spacers of the first-third spacer group S1-3 extend may deviate from the direction in which the spacers of the first-second spacer group S1-2 extend. The direction in which the spacers of the first-third spacer group S1-3 extend may intersect or, in some instances, be orthogonal to the direction in which the spacers of the first-second spacer group S1-2 extend.

The direction in which the spacers of the first-third spacer group S1-3 extend may be identical to the direction in which the spacers of the first-first spacer group S1-1 extend.

The plurality of spacer groups included in the plurality of first spacers S1 may further include a first-fourth spacer group S1-4. The first-fourth spacer group S1-4 may be spaced apart from the first-third spacer group S1-3 in the second direction D2. The first-fourth spacer group S1-4 may be spaced apart from the first-third spacer group S1-3 in a direction opposite to a direction from the first-third spacer group S1-3 toward the first-second spacer group S1-2.

The spacers of the first-fourth spacer group S1-4 may each extend in the direction deviating from the first direction D1 and the second direction D2 when viewed in the direction perpendicular to the substrate 110 (e.g., the fourth direction). The direction in which the spacers of the first-fourth spacer group S1-4 extend may deviate from the direction in which the spacers of the first-third spacer group S1-3 extend. The direction in which the spacers of the first-fourth spacer group S1-4 extend may intersect or, in some instances, be orthogonal to the direction in which the spacers of the first-third spacer group S1-3 extend.

The direction in which the spacers of the first-fourth spacer group S1-4 extend may be identical to the direction in which the spacers of the first-second spacer group S1-2 extend.

With reference to FIG. 5, the plurality of second spacers S2 and the plurality of third spacers S3 may include a plurality of spacer groups when viewed in the direction perpendicular to the substrate 110. The plurality of spacer groups may each be defined by spacers extending in the same direction and disposed adjacent to one another. In one embodiment, the plurality of first spacers S1 and the plurality of second spacers S2 are symmetrical across a center line of the second anode 132B that extends in the second direction D2. While the plurality of second spacers S2 and the plurality of third spacers S3 are symmetrical across a center line of the third anode 132C that extends in the second direction D2.

The properties of the plurality of spacer groups included in the plurality of second spacers S2 and the plurality of third spacers S3 may be identical to the properties of the plurality of spacer groups included in the plurality of first spacers S1.

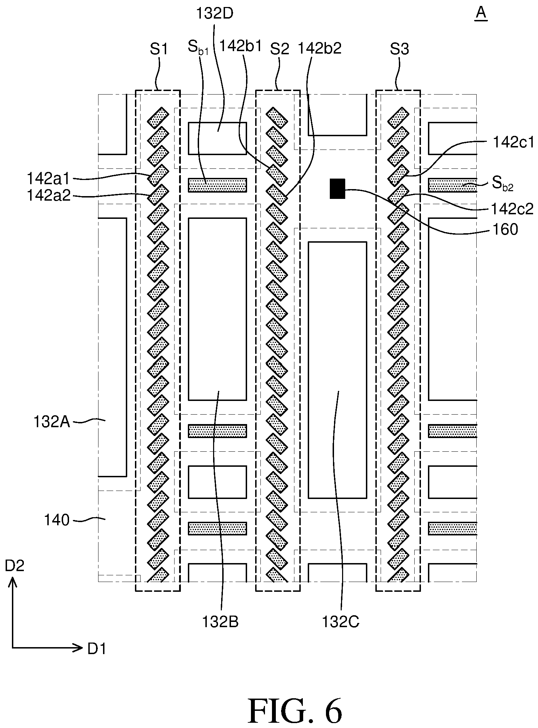

FIG. 6 is a view illustrating another example of a schematic enlarged top plan view of area A in FIG. 1 and an area at the periphery of area A according to an exemplary embodiment of the present disclosure.

The example illustrated in FIG. 6 may be substituted for the examples illustrated in FIGS. 4 and 5 or present at the periphery of the examples illustrated in FIGS. 4 and 5. For reference, the description of the configurations identical to or duplicative of those described above with reference to FIG. 6 may be omitted.

With reference to FIG. 6, the organic light-emitting display device 100 according to the exemplary embodiment of the present specification may include at least one spacer bar. The spacer bar may be disposed between the plurality of first spacers S1 and the plurality of second spacers S2 when viewed in the direction perpendicular to the substrate 110.

A first spacer bar $S_{b1}$ may be spaced apart from the second anode 132B in the second direction D2 when viewed in the direction perpendicular to the substrate 110 and extend in the first direction D1 when viewed in the direction perpendicular to the substrate 110. The first spacer bar $S_{b1}$ may be disposed between the second anode 132B and a fourth anode 132D. In this case, the fourth anode 132D may be disposed on the substrate 110 and spaced apart from the second anode 132B in the second direction D2.

A second spacer bar $S_{b2}$ may be spaced apart from the first spacer bar Sb1 in the first direction D1, and the auxiliary spacer 160 may be disposed between the first spacer bar Sb1 and the second spacer bar $S_{b2}$. In addition, other spacer bars may, of course, be further disposed between the anodes.

The spacer bar is a bar-type spacer. The direction in which the spacer bar extends may mean the direction of the major axis (e.g., a length) of the spacer bar when viewed in the direction perpendicular to the substrate 110.

The direction of the major axis of the spacer bar may be parallel to the direction of a minor axis (e.g., a width) of each of the anodes disposed at the periphery of the spacer bar. A length of the major axis of the spacer bar may be equal to a length of the minor axis of the anode disposed at the periphery of the spacer bar when viewed in the direction perpendicular to the substrate 110.

As described above, the bar-shaped spacer bar is disposed between the plurality of spacers, such that the bonding force for the organic layer is increased, and the separation of the organic layer is effectively suppressed when the foldable display is folded. In addition, because the spacer bar is further provided, it is possible to obtain both the advantage of the pattern-shaped spacer and the advantage of the bar-shaped spacer.

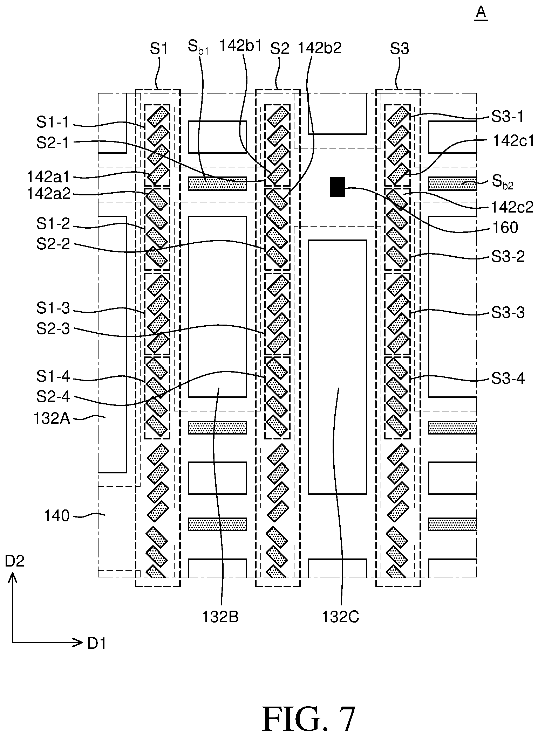

FIG. 7 is a view illustrating still another example of a schematic enlarged top plan view of area A in FIG. 1 and an area at the periphery of area A, according to an exemplary embodiment of the present disclosure.

The example illustrated in FIG. 7 may be substituted for the examples illustrated in FIGS. 4 to 6 or present at the periphery of the examples illustrated in FIGS. 4 to 6. For reference, the description of the configurations identical to or duplicative of those described with reference to FIG. 7 may be omitted.

With reference to FIG. 7, the first spacer bar $S_{b1}$ may be disposed between the first-first spacer group S1-1 and the second-first spacer group S2-1. Because properties of the first-first spacer group S1-1 and the second-first spacer group S2-1, which are disposed at the periphery of the first spacer bar Sb1, are identical to or duplicative of those described above with reference to FIG. 5, the description thereof may be omitted.

FIG. 8 is a view illustrating yet another example of a schematic enlarged top plan view of area A in FIG. 1 and an area at the periphery of area A, according to an exemplary embodiment of the present disclosure. For reference, the description of the configurations identical to or duplicative of those described above with reference to FIG. 8 may be omitted.

With reference to FIG. 8, the organic light-emitting display device 100 according to the exemplary embodiment of the present specification may include anodes extending in the first direction D1 when viewed in the direction perpendicular to the substrate 110. The bank layer 140 may cover edges of the anodes extending in the first direction D1 and at least expose a central portion of each of the anodes. That is, the anodes in FIG. 8 may have a major axis (e.g., a length) in a direction parallel to the first direction D1, and a minor axis (e.g., a width) in a direction parallel to the second direction D2. The anodes in FIG. 8 differ from the anodes in FIGS. 4 to 7 in that the anodes are folded in a direction of the minor axis.

With reference to FIG. 8, the organic light-emitting display device 100 according to the exemplary embodiment of the present specification may include a plurality of fourth spacers S4, and the plurality of fourth spacers S4 may be provided on the bank layer 140 and disposed in the second direction D2. That is, the direction in which the plurality of fourth spacers S4 is disposed may be a direction parallel to the direction of the minor axis of the anode.

A length of each of the plurality of fourth spacers S4 may extend in the direction deviating from the first direction D1 and the second direction D2 when viewed in the direction perpendicular to the substrate 110. That is, a length of the plurality of fourth spacers S4 may extend in a fourth direction that is different from the first direction D1 and the second direction D2 when viewed in a plan view of the display device 100. The direction in which the plurality of fourth spacers S4 each extends may be different from the first direction D1 and the second direction D2.

The organic light-emitting display device 100 according to the exemplary embodiment of the present specification may include a plurality of fifth spacers S5. The plurality of fifth spacers S5 provided on the bank layer 140, disposed in the second direction D2, and spaced apart from the plurality of fourth spacers S4 in the first direction D1. That is, the direction in which the plurality of fifth spacers S5 is disposed may be a direction parallel to the direction of the minor axis (e.g., a width) of the anode.

A fifth anode 132E and a sixth anode 132F may be disposed between the plurality of fourth spacers S4 and the plurality of fifth spacers S5 when viewed in the direction perpendicular to the substrate 110.

A length of each of the plurality of fifth spacers S5 may extend in the direction deviating from the first direction D1 and the second direction D2 when viewed in the direction perpendicular to the substrate 110. That is, the length of the plurality of fifth spacers S5 may extend in the third direction that is different from the first direction D1, the second direction S2, and the fourth direction when viewed in the plan view of the display device 100. The direction in which the plurality of fifth spacers S5 each extends may be different from the first direction D1 and the second direction D2. The direction in which the plurality of fifth spacers S5 each extends may intersect or, in some instances, be orthogonal to the direction in which the plurality of fourth spacers S4 each extends.

The organic light-emitting display device 100 according to the exemplary embodiment of the present specification may further include a plurality of sixth spacers S6 spaced apart from the plurality of fourth spacers S4 in the second direction D2, and a plurality of seventh spacers S7 spaced apart from the plurality of fifth spacers S5 in the second direction D2. The sixth spacers S6 extend in the fourth direction whereas the seventh spacers S7 extend in the third direction.

Because the anodes in FIG. 8 are folded in the direction of the minor axis (e.g., a width), the anode may be suitable for a folding structure having a larger curvature. Correspondingly, a length of each of the plurality of fourth to seventh spacers S4, S5, S6, and S7 in the second direction D2 may be shorter than a length of each of the plurality of first to third spacers S 1, S2, and S3 in FIGS. 4 to 7 in the second direction D2.

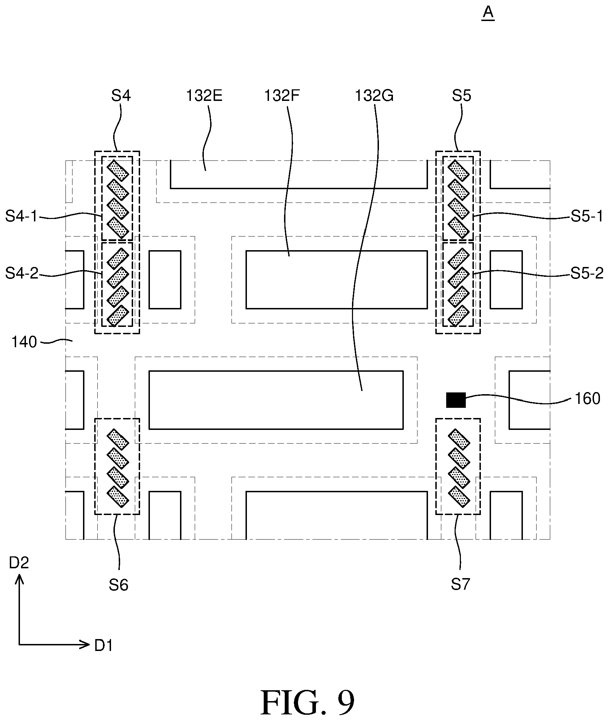

FIG. 9 is a view illustrating still yet another example of a schematic enlarged top plan view of area A in FIG. 1 and an area at the periphery of area A, according to an exemplary embodiment of the present disclosure.

The example illustrated in FIG. 9 may be substituted for the examples illustrated in FIGS. 4 and 8 or present at the periphery of the examples illustrated in FIGS. 4 and 8. For reference, the description of the configurations identical to or duplicative of those described above with reference to FIG. 9 may be omitted.

With reference to FIG. 9, the plurality of fourth spacers S4 may include a plurality of spacer groups when viewed in the direction perpendicular to the substrate 110. The plurality of spacer groups may each be defined by spacers extending in the same direction and disposed adjacent to one another.

The plurality of spacer groups included in the plurality of fourth spacers S4 may at least include a fourth-first spacer group S4-1, and a fourth-second spacer group S4-2 spaced apart from the fourth-first spacer group S4-1 in the second direction D2.

A length of each of the spacers of the fourth-first spacer group S4-1 may extend in the direction deviating from the first direction D1 and the second direction D2 when viewed in the direction perpendicular to the substrate 110. That is, the length of the fourth-first spacer group S4-1 may extend in the fourth direction that is different from the first direction D1 and the second direction D2 when viewed in a plan view of the display device 100. The direction in which the spacers of the fourth-first spacer group S4-1 may be different from the first direction D1 and the second direction D2.

The spacers of the fourth-second spacer group S4-2 may each extend in the direction deviating from the first direction D1 and the second direction D2 when viewed in the direction perpendicular to the substrate 110. That is, the length of the fourth-second spacer group S4-2 may extend in the third direction that is different from the first direction D1, the second direction S2, and the fourth direction when viewed in the plan view of the display device 100. However, the direction in which the spacers of the fourth-second spacer group S4-2 extend may deviate from the direction in which the spacers of the fourth-first spacer group S4-1 extend. The direction in which the spacers of the fourth-second spacer group S4-2 extend may intersect or, in some instances, be orthogonal to the direction in which the spacers of the fourth-first spacer group S4-1 extend.

The spacers of the fourth-first spacer group S4-1 and the spacers of the fourth-second spacer group S4-2 may not overlap one another when viewed in the direction parallel to the first direction D1.

With reference to FIG. 9, the plurality of fifth spacers S5 may include a plurality of spacer groups when viewed in the direction perpendicular to the substrate 110. The plurality of spacer groups may each be defined by spacers extending in the same direction and disposed adjacent to one another.

The plurality of spacer groups included in the plurality of fifth spacers S5 may at least include a fifth-first spacer group S5-1, and a fifth-second spacer group S5-2 spaced apart from the fifth-first spacer group S5-1 in the second direction D2.

The spacers of the fifth-first spacer group S5-1 may each extend in the fourth direction deviating from the first direction D1, the second direction D2, and the third direction when viewed in the direction perpendicular to the substrate 110 (e.g., the third direction). The direction in which the spacers of the fifth-first spacer group S5-1 may be different from the first direction D1 and the second direction D2.

The spacers of the fifth-second spacer group S5-2 may each extend in the third direction deviating from the first direction D1, the second direction D2, and the fourth direction when viewed in the direction perpendicular to the substrate 110 (e.g., the plan view). However, the direction in which the spacers of the fifth-second spacer group S5-2 extend may deviate from the direction in which the spacers of the fifth-first spacer group S5-1 extend. The direction in which the spacers of the fifth-second spacer group S5-2 extend may intersect or, in some instances, be orthogonal to the direction in which the spacers of the fifth-first spacer group S5-1 extend.

The spacers of the fifth-first spacer group S5-1 and the spacers of the fifth-second spacer group S5-2 may not overlap one another when viewed in the direction parallel to the first direction D1.

In addition, the direction in which the spacers of the fifth-first spacer group S5-1 extend may deviate from the direction in which the spacers of the fourth-first spacer group S4-1 extend. The direction in which the spacers of the fifth-first spacer group S5-1 extend may intersect or, in some instances, be orthogonal to the direction in which the spacers of the fourth-first spacer group S4-1 extend.

With reference to FIG. 9, the plurality of sixth spacers S6 may each extend in the fourth direction deviating from the first direction D1 and the second direction D2 when viewed in the direction perpendicular to the substrate 110 (e.g., the third direction). The direction in which the plurality of sixth spacers S6 each extends may be different from the first direction D1 and the second direction D2.

The direction in which the plurality of sixth spacers S6 each extends may deviate from the direction in which the spacers of the fourth-second spacer group S4-2 extend. The direction in which the plurality of sixth spacers S6 each extends may intersect or, in some instances, be orthogonal to the direction in which the spacers of the fourth-second spacer group S4-2 extend. In addition, the direction in which the plurality of sixth spacers S6 each extends may be identical to the direction in which the spacers of the fourth-first spacer group S4-1 extend.

With reference to FIG. 9, the plurality of seventh spacers S7 may each extend in the fourth direction deviating from the first direction D1 and the second direction D2 when viewed in the direction perpendicular to the substrate 110 (e.g., the third direction). The direction in which the plurality of seventh spacers S7 each extends may be different from the first direction D1 and the second direction D2.

The direction in which the plurality of seventh spacers S7 each extends may deviate from the direction in which the spacers of the fifth-second spacer group S5-2 extend. The direction in which the plurality of seventh spacers S7 each extends may intersect or, in some instances, be orthogonal to the direction in which the spacers of the fifth-second spacer group S5-2 extend. In addition, the direction in which the plurality of seventh spacers S7 each extends may be identical to the direction in which the spacers of the fifth-first spacer group S5-1 extend.

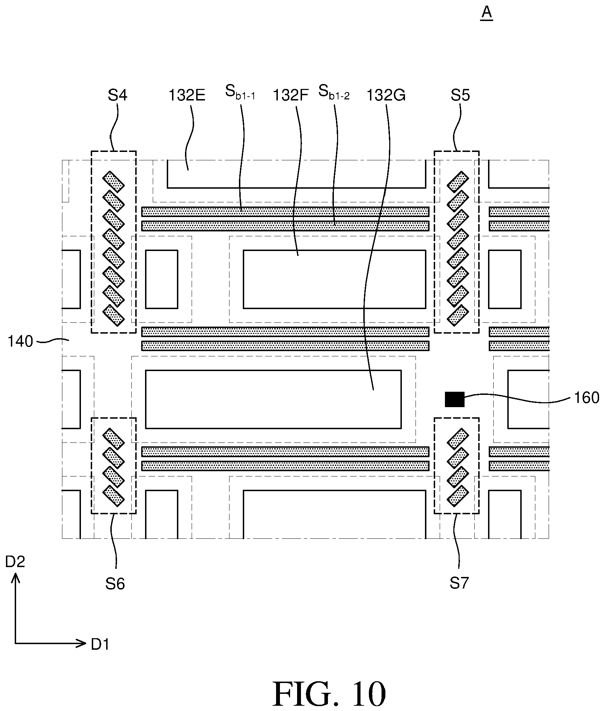

FIG. 10 is a view illustrating still yet another example of a schematic enlarged top plan view of area A in FIG. 1 and an area at the periphery of area A, according to an exemplary embodiment of the present disclosure.

The example illustrated in FIG. 10 may be substituted for the examples illustrated in FIGS. 4 and 9 or present at the periphery of the examples illustrated in FIGS. 4 and 9. For reference, the description of the configurations identical to or duplicative of those described above with reference to FIG. 10 may be omitted.

With reference to FIG. 10, at least two spacer bars $S_{b1-1}$ and $S_{b1-2}$ may extend in the first direction D1. The at least two spacer bars $S_{b1-1}$ and $S_{b1-2}$ may be disposed between the fifth anode 132E and the sixth anode 132F when viewed in the direction perpendicular to the substrate 110. A major axis (e.g., a length) of the fifth anode 132E and a major axis of the sixth anode 132F may extend in the first direction D1, and a minor axis (e.g., a width) of the fifth anode 132E and a minor axis of the sixth anode 132F may extend in the second direction D2.

The at least two spacer bars $S_{b1-1}$ and $S_{b1-2}$ may be disposed between the plurality of fourth spacers S4 and the plurality of fifth spacers S5.

The first-first spacer bar $S_{b1-1}$ may be spaced apart from the fifth anode 132E in the second direction D2 when viewed in the direction perpendicular to the substrate 110. The first-second spacer bar $S_{b1-2}$ may be spaced apart from the first-first spacer bar Sb1-1 in the second direction D2 when viewed in the direction perpendicular to the substrate 110. The first-first spacer bar $S_{b1-1}$ and the first-second spacer bar $S_{b1-2}$ may be disposed between the fifth anode 132E and the sixth anode 132F.

A length of the first-first spacer bar $S_{b1-1}$ may be equal to a length of the first-second spacer bar $S_{b1-2}$ when viewed in the direction perpendicular to the substrate 110. In addition, the length of the first-first spacer bar $S_{b1-1}$ and the length of the first-second spacer bar $S_{b1-2}$ may be equal to the length of the major axis (e.g., a length) of the fifth anode 132E.

In other words, the direction of the major axis of the spacer bar may be parallel to the direction of the major axis of each of the anodes disposed at the periphery of the spacer bar. A length of the major axis of the spacer bar may be equal to a length of the major axis of the anode disposed at the periphery of the spacer bar when viewed in the direction perpendicular to the substrate 110.

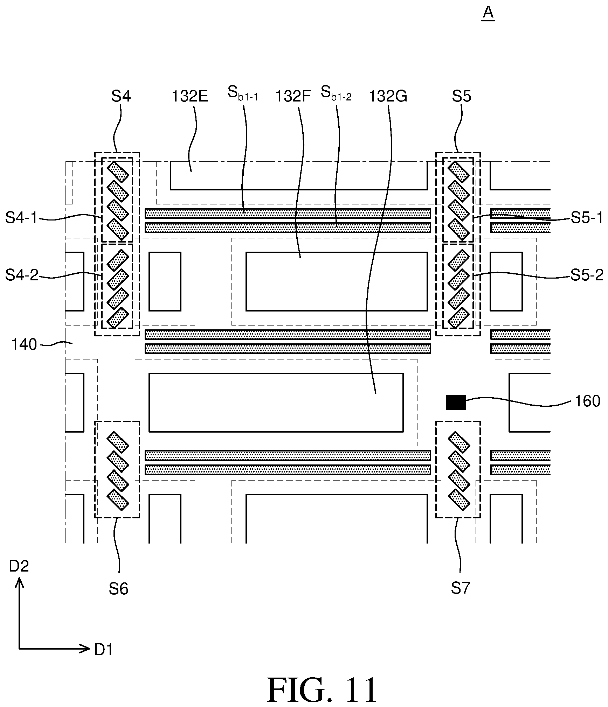

FIG. 11 is a view illustrating still another further example of a schematic enlarged top plan view of area A in FIG. 1 and an area at the periphery of area A, according to an exemplary embodiment of the present disclosure.

The example illustrated in FIG. 11 may be substituted for the examples illustrated in FIGS. 4 and 10 or present at the periphery of the examples illustrated in FIGS. 4 and 10. For reference, the description of the configurations identical to or duplicative of those described above with reference to FIG. 11 may be omitted.

With reference to FIG. 11, the first-first spacer bar $S_{b1-1}$ and the first-second spacer bar $S_{b1-2}$ may be disposed between the fifth anode 132E and the sixth anode 132F when viewed in the direction perpendicular to the substrate 110, and the first-first spacer bar $S_{b1-1}$ and the first-second spacer bar $S_{b1-2}$ may be disposed between the fourth-first spacer group S4-1 and the fifth-first spacer group S5-1.

The second-first spacer bar and the second-second spacer bar may be disposed between the sixth anode 132F and a seventh anode 132G when viewed in the direction perpendicular to the substrate 110, and the second-first spacer bar and the second-second spacer bar may be disposed between the fourth-second spacer group S4-2 and the fifth-second spacer group S5-2.

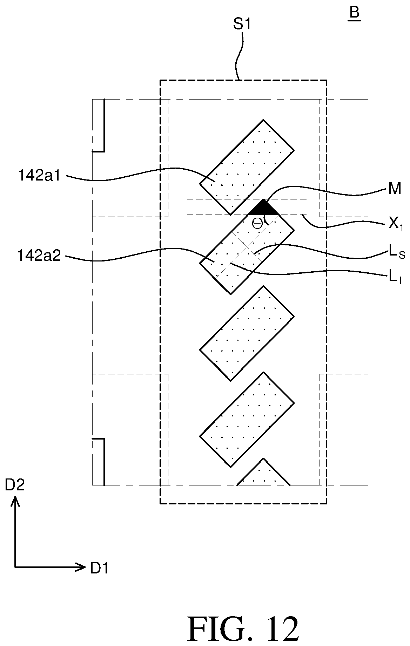

FIG. 12 is a view illustrating one example of a schematic enlarged top plan view of area B in FIG. 4 according to one embodiment. For reference, the description of the configurations identical to or duplicative of those described above with reference to FIG. 12 may be omitted.

With reference to FIG. 12, the first-second spacer 142a2 may have a major axis Li and a minor axis $L_s$ when viewed in the direction perpendicular to the substrate 110. The major axis Li is along the third direction. The first-first spacer 142a1 may have the same shape properties as the first-second spacer 142a2. In addition, the other spacers may also have the same properties as the first-second spacer 142a2.

A ratio between the major axis Li and the minor axis $L_s$ of the first-second spacer 142a2 may be 3:1. For example, when the major axis Li of the first-second spacer 142a2 is 9 $\mu$m, the minor axis $L_s$ of the first-second spacer 142a2 may be 3 $\mu$m. If the first-second spacer 142a2 has an isotropic shape such as a square or circular shape when viewed in the direction perpendicular to the substrate 110, the first-second spacer 142a2 hardly overlaps other spacers.

A portion of the first-second spacer 142a2 may overlap one edge (e.g., a portion) of the first-first spacer when viewed in the direction parallel to the first direction D1. That is, the first-second spacer 142a2 may have the overlap area M in which the first-second spacer 142a2 overlaps the first-first spacer 142a1. In this case, one edge of the first-first spacer 142a1 may be an edge closest to the first-second spacer 142a2 among the edges of the first-first spacer 142a1.

An acute angle between the major axis Li of the first-second spacer 142a2 and a first imaginary axis $X_1$ (e.g., a reference) extending in the first direction D1 based on one edge of the first-first spacer 142a1 may be 30 degrees or more and less than 60 degrees. That is, an acute angle between the first direction D1 and the major axis Li of the first-second spacer 142a2 may be 30 degrees or more and 60 degrees or less. In case that the acute angle between the first direction D1 and the major axis Li of the first-second spacer 142a2 is 30 degrees or more and 60 degrees or less, the area of the overlap area M of the first-second spacer 142a2 is appropriately defined, such that the bonding force for the organic layer is increased, and the separation of the organic layer is effectively suppressed when the foldable display is folded.

As described above, the overlap area M in which the first-second spacer 142a2 overlaps the first-first spacer 142a1 when viewed in the direction parallel to the first direction D1 may have an area that satisfies Equation 1 below when viewed in the direction perpendicular to the substrate 110.

[Equation 1]

$$Area\ M = \frac{L_s^2}{18}\ tan\theta$$

(here, Area M is an area ($\mu$m$^2$) of the overlap area M in which the first-second spacer 142a2 overlaps the first-first spacer 142a1 when viewed in the direction perpendicular to the substrate 110, $L_s$ is a length ($\mu$m) of the minor axis $L_s$ of the first-second spacer 142a2, and $\theta$ is an acute angle (°) between the major axis Li of the first-second spacer 142a2 and the first direction D1).

For example, when the major axis Li of the first-second spacer 142a2 is 9 $\mu$m, the minor axis $L_s$ of the first-second spacer 142a2 may be 3 $\mu$m. In case that the acute angle between the first direction D1 and the major axis Li of the first-second spacer 142a2 is 30 degrees or more and 60 degrees or less, the area of the overlap area derived from Equation 1 above when viewed in the direction perpendicular to the substrate 110 may be 0.29 $\mu$m$^2$ to 0.86 $\mu$m$^2$. In case that the area of the overlap area is 0.29 $\mu$m$^2$ to 0.86 $\mu$m$^2$, the area of the overlap area M of the first-second spacer 142a2 is appropriately defined, such that the bonding force for the organic layer is increased, and the separation of the organic layer is effectively suppressed when the foldable display is folded.

Exemplary embodiments of the present disclosure can also be described as follows:

According to an aspect of the present disclosure, there is provided an organic light-emitting display device. The organic light-emitting display device comprises a substrate having a folding axis extending in a first direction, the substrate including a folding area configured to be curved to surround the folding axis in a second direction intersecting the first direction; a first anode disposed on the substrate; a bank layer disposed on the substrate to at least expose a central portion of the first anode; and a plurality of first spacers provided on the bank layer in the folding area and disposed in the second direction. The plurality of first spacers comprises a first-first spacer extending in a direction deviating from the first direction and the second direction when viewed in a direction perpendicular to the substrate; and a first-second spacer spaced apart from the first-first spacer in the second direction and extending in a direction parallel to the direction in which the first-first spacer extends. The first-first spacer and the first-second spacer at least partially overlap each other when viewed in a direction parallel to the first direction.

The plurality of first spacers each may have an inversely tapered structure.

The organic light-emitting display device may further comprise a second anode disposed on the substrate and spaced apart from the first anode in the first direction. The plurality of first spacers may be disposed between the first anode and the second anode.

The organic light-emitting display device may further comprise a plurality of second spacers provided on the bank layer, disposed in the second direction, and spaced apart from the plurality of first spacers in the first direction.

The second anode may be disposed between the plurality of first spacers and the plurality of second spacers.

The plurality of second spacers may comprise a second-first spacer extending in a direction deviating from the first direction and the second direction when viewed in the direction perpendicular to the substrate; and a second-second spacer spaced apart from the second-first spacer in the second direction and extending in a direction parallel to the direction in which the second-first spacer extends.

The second-first spacer and the second-second spacer may at least partially overlap each other when viewed in the direction parallel to the first direction.

The organic light-emitting display device may further comprise a third anode disposed on the substrate and spaced apart from the second anode in a direction opposite to a direction from the second anode toward the first anode.

The organic light-emitting display device may further comprise a plurality of third spacers provided on the bank layer, disposed in the second direction, and spaced apart from the plurality of second spacers in the first direction. The third anode may be disposed between the plurality of second spacers and the plurality of third spacers when viewed in the direction perpendicular to the substrate.

The organic light-emitting display device may further comprise an auxiliary spacer disposed on the bank layer and spaced apart from the third anode in the second direction. The auxiliary spacer may have a different shape and may be oriented in a different direction from the first, second, and third spacers S1, S2, and S3.

The auxiliary spacer may be disposed between the plurality of second spacers and the plurality of third spacers.

The organic light-emitting display device may further comprise at least one spacer bar disposed between the plurality of first spacers and the plurality of second spacers when viewed in the direction perpendicular to the substrate.

The at least one spacer bar may be spaced apart from the second anode in the second direction when viewed in the direction perpendicular to the substrate and extend in the first direction when viewed in the direction perpendicular to the substrate.

The organic light-emitting display device may further comprise a fourth anode disposed on the substrate and spaced apart from the second anode in the second direction. The at least one spacer bar may be disposed between the second anode and the fourth anode.

A ratio between a major axis (e.g., a length) and a minor axis (e.g., a width) of each of the plurality of first spacers may be 3: 1.

An acute angle between the first direction and the major axis may be 30 degrees or more and 60 degrees or less.

An overlap area in which the first-second spacer overlaps the first-first spacer when viewed in the direction parallel to the first direction may have an area that satisfies Equation 1 below when viewed in the direction perpendicular to the substrate.

[Equation 1]

$$Area\ M = \frac{L_S^2}{18}\ tan\theta$$

Area M is an area ($\mu m^2$) of the overlap area of the first-second spacer when viewed in the direction perpendicular to the substrate, Ls is a length ($\mu m$) of a minor axis of the first-second spacer, and $\theta$ is an acute angle (°) between a major axis of the first-second spacer and the first direction.

An overlap area in which the first-second spacer overlaps the first-first spacer when viewed in the direction parallel to the first direction may have an area of 0.29 $\mu m^2$ to 0.86 $\mu m^2$ when viewed in the direction perpendicular to the substrate.

According to another aspect of the present disclosure, there is provided an organic light-emitting display device. The organic light-emitting display device comprises a substrate having a folding axis extending in a first direction, the substrate including a folding area configured to curve around the folding axis in a second direction that intersects the first direction while the substrate is folded; a transistor on the substrate; a first anode connected to the transistor; a bank layer on a portion of the first anode; a light emitting part on the first anode; a cathode on the light emitting part and the bank layer; a first spacer on the bank layer and at a first side of the first anode, the first spacer extending in a third direction that is different from the first direction and the second direction in a plan view of the substrate; a second spacer on the bank layer at the first side of the first anode and spaced apart from the first spacer in the second direction, the second spacer extending in the third direction; and a sealing part on the cathode, at least a portion of the sealing part in contact with a side surface of the first spacer and a side surface of the second spacer. At least a portion of the first spacer and a portion of the second spacer overlap in the first direction.

The sealing part may include a plurality of sealing layers and one of the sealing layers may be in contact with the side surface of the first spacer and the side surface of the second spacer and may be in contact with an upper surface of the first spacer and an upper surface of the second spacer.

Each of the first spacer and the second spacer may have an inversely tapered structure.

The organic light-emitting display device may further comprise a third spacer on the bank layer at a second side of the first anode, the third spacer extending in a fourth direction different from the first direction, the second direction, and the third direction in the plan view; and a fourth spacer on the bank layer at the second side of the first anode and spaced apart from the third spacer in the second direction in the plan view, the fourth spacer extending in the fourth direction. At least a portion of the third spacer and a portion of the fourth spacer may overlap in the first direction, and the portion of the sealing part may be in contact with a side surface of the third spacer and a side surface of the fourth spacer.

The organic light-emitting display device may further comprise a second anode at the second side of the first anode such that the third spacer and the fourth spacer are between the first anode and the second anode.

The organic light-emitting display device may further comprise an auxiliary spacer on the bank layer, the auxiliary spacer spaced apart from the second anode in the second direction in the plan view. The auxiliary spacer may have a shape that is different from a shape of the first spacer, the second spacer, the third spacer, and the fourth spacer and the first spacer, the second spacer, the third spacer, and the fourth spacer have a same shape.

The organic light-emitting display device may further comprise a first spacer bar that is spaced apart from the first anode in the second direction in the plan view, the first spacer bar having a same width as the first anode.

The first spacer and the third spacer may be symmetrical along a center line of the first anode that extends along the second direction, and the second spacer and the fourth spacer may be symmetrical along the center line.

The organic light-emitting display device may further comprise a fifth spacer on the bank layer at the second side of the first anode and spaced apart from the second spacer in the second direction, the fifth spacer extending in the fourth direction; and a sixth spacer on the bank layer at the second side of the first anode and spaced apart from the fourth spacer in the second direction in the plan view, the fourth spacer extending in the third direction.

Although exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims.

**Claims**

1. An organic light-emitting display device (100) comprising:

    a substrate (110) having a folding axis extending in a first direction (D1), the substrate (110) including a folding area (FA1, FA2) configured to be curved to surround the folding axis in a second direction (D2) that intersects the first direction (D1) while the substrate (110) is folded;
    a first anode (132A) on the substrate (110);
    a bank layer (140) on the substrate (110) that exposes a central portion of the first anode (132A); and
    a plurality of first spacers (S1) arranged on the bank layer (140) in the folding area (FA1, FA2) along the second direction (D2),
    wherein the plurality of first spacers (S1) comprises:

    a first-first spacer (142a1) extending in a direction that is different from the first direction (D1) and the second direction (D2) when viewed in a plan view of the substrate (110); and
    a first-second spacer (142a2) spaced apart from the first-first spacer (142a1) in the second direction (D2) and extending in a direction parallel to the direction in which the first-first spacer (142a1) extends,
    wherein the first-first spacer (142a1) and the first-second spacer (142a2) at least partially overlap each other when viewed in a direction parallel to the first direction (D1).

2. The organic light-emitting display device (100) of claim 1, wherein each of the plurality of first spacers (S1) has an inversely tapered structure.

3. The organic light-emitting display device (100) of claim 1 or 2, further comprising:
    a second anode (132B) on the substrate (110) and spaced apart from the first anode (132A) in the first direction (D 1), wherein the plurality of first spacers (S1) are between the first anode (132A) and the second anode (132B).

4. The organic light-emitting display device (100) of claim 3, further comprising: a plurality of second spacers (S2) arranged on the bank layer (140) along the second direction (D2) and spaced apart from the plurality of first spacers (S1) in the first direction (D1).

5. The organic light-emitting display device (100) of claim 4, wherein the plurality of second spacers (S2) comprises:

a second-first spacer (142b1) extending in a direction deviating from the first direction (D1) and the second direction (D2) in the plan view of the substrate (110); and
a second-second spacer (142b2) spaced apart from the second-first spacer (142b1) in the second direction (D2) and extending in a direction parallel to the direction in which the second-first spacer (142b1) extends.

6. The organic light-emitting display device (100) of claim 5, wherein the second-first spacer (142b1) and the second-second spacer (142b2) at least partially overlap each other when viewed in the direction parallel to the first direction (D1).

7. The organic light-emitting display device (100) of any of claims 4 to 6, further comprising:
a third anode (132C) on the substrate (110) and spaced apart from the second anode (132B) in the first direction (D1) such that the second anode (132B) is between the first anode (132A) and the third anode (132C).

8. The organic light-emitting display device (100) of claim 7, further comprising:

a plurality of third spacers (S3) arranged on the bank layer (140) along the second direction (D2), and spaced apart from the plurality of second spacers (S2) in the first direction (D1),
wherein the third anode (132C) is between the plurality of second spacers (S2) and the plurality of third spacers (S3) when viewed in the plan view.

9. The organic light-emitting display device (100) of claim 8, further comprising:

an auxiliary spacer (160) on the bank layer (140) and spaced apart from the third anode (132C) in the second direction (D2),
wherein the auxiliary spacer (160) is between the plurality of second spacers (S2) and the plurality of third spacers (S3).

10. The organic light-emitting display device (100) of any of claims 4 to 9, further comprising:
at least one spacer bar ($S_{b1}$) between the plurality of first spacers (S1) and the plurality of second spacers (S2) in the plan view.

11. The organic light-emitting display device (100) of claim 10, wherein the at least one spacer bar ($S_{b1}$) is spaced apart from the second anode (132B) in the second direction (D2) when viewed in the plan view and the at least one spacer ($S_{b1}$) bar extends in the first direction (D1) in the plan view.

12. The organic light-emitting display device (100) of claim 11, further comprising:

a fourth anode (132D) on the substrate (110) and spaced apart from the second anode (132B) in the second direction (D2),
wherein the at least one spacer bar ($S_{b1}$) is between the second anode (132B) and the fourth anode (132D).

13. The organic light-emitting display device (100) of any of claims 1 to 12, wherein a ratio between a major axis and a minor axis of each of the plurality of first spacers (S1) is 3:1.

14. The organic light-emitting display device (100) of claim 13, wherein an acute angle between the first direction (D1) and the major axis is in a range between 30 and 60 degrees.

15. The organic light-emitting display device (100) of any of claims 1 to 14, wherein an overlap area in which the first-second spacer (142a2) overlaps the first-first spacer (142a1) when viewed in the direction parallel to the first direction (D1) has an area that satisfies Equation 1 below when viewed in the plan view, and

[Equation 1]

$$Area\ M = \frac{L_s^2}{18}\ tan\theta$$

wherein Area M is an area of the overlap area of the first-second spacer (142a2) when viewed in the plan view, $L_s$ is a length of a minor axis of the first-second spacer (142a2), and $\theta$ is an acute angle between a major axis of the first-second spacer (142a2) and the first direction (D1).

FIG. 1

**FIG. 2**

100

130

136    134    132                          142

158
156
154
150
152

140

118

116

114
112
110

124 122 128 126
120

FIG. 3

FIG. 4

FIG. 5

FIG. 6

A

S1  S$_{b1}$  142b1  S2  142b2  S3

S1-1
S2-1
142a1
142a2
S1-2
S2-2
S1-3
S2-3
S1-4
S2-4
132A

140

S3-1
142c1
S$_{b2}$
142c2
160
S3-2
S3-3
S3-4

D2

D1

132B  132C

# FIG. 7

A

S4      132E    132F    132G    S5

140

160

D2

D1

S6              S7

FIG. 8

A

S4    132E    132F    132G    S5

S4-1    S5-1

S4-2    S5-2

140    160

D2

S6    S7

D1

# FIG. 9

A

S4  132E  S$_{b1-1}$  132F  S$_{b1-2}$  132G  S5

140

160

S6

S7

D2

D1

FIG. 10

A

S4    132E    S$_{b1-1}$    132F    S$_{b1-2}$    132G    S5

S4-1

S4-2

140

S5-1

S5-2

160

D2

D1

S6    S7

FIG. 11

FIG. 12

Europäisches
Patentamt

European
Patent Office

Office européen
des brevets

# EUROPEAN SEARCH REPORT

Application Number

EP 23 21 8549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/416193 A1 (LEE KYOUNGMOOK [KR]) 29 December 2022 (2022-12-29) * paragraphs [0039], [0111]; figures 1,6,8 * | 1-8 | INV. H10K59/122 |
| X | CN 114 187 848 A (SAMSUNG DISPLAY CO LTD) 15 March 2022 (2022-03-15) * figures 1A,1B, 2,5A, 8A,8B * | 1-6 | |
| X | US 2021/280647 A1 (HAN BYUNGUK [KR] ET AL) 9 September 2021 (2021-09-09) * paragraph [0068]; figures 1,8,9,14 * | 1-8,13 | |
| X | KR 2020 0051150 A (LG DISPLAY CO LTD [KR]) 13 May 2020 (2020-05-13) * figures 1b,1c,2,4a,4b * | 1-15 | |

TECHNICAL FIELDS
SEARCHED (IPC)

H10K

The present search report has been drawn up for all claims

| Place of search | Date of completion of the search | Examiner |
|---|---|---|
| The Hague | 21 May 2024 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 8549

21-05-2024

| Patent document cited in search report | Publication date | Patent family member(s) | | Publication date |
|---|---|---|---|---|
| US 2022416193 A1 | 29-12-2022 | CN | 115602689 A | 13-01-2023 |
| | | DE | 102022115788 A1 | 29-12-2022 |
| | | GB | 2610686 A | 15-03-2023 |
| | | GB | 2624979 A | 05-06-2024 |
| | | KR | 20230000321 A | 02-01-2023 |
| | | US | 2022416193 A1 | 29-12-2022 |
| CN 114187848 A | 15-03-2022 | CN | 114187848 A | 15-03-2022 |
| | | KR | 20220025965 A | 04-03-2022 |
| | | US | 2022059626 A1 | 24-02-2022 |
| US 2021280647 A1 | 09-09-2021 | CN | 113380857 A | 10-09-2021 |
| | | JP | 2021141067 A | 16-09-2021 |
| | | KR | 20210114094 A | 23-09-2021 |
| | | US | 2021280647 A1 | 09-09-2021 |
| | | US | 2024040852 A1 | 01-02-2024 |
| KR 20200051150 A | 13-05-2020 | CN | 111146246 A | 12-05-2020 |
| | | KR | 20200051150 A | 13-05-2020 |
| | | KR | 20240036541 A | 20-03-2024 |
| | | US | 2020144540 A1 | 07-05-2020 |
| | | US | 2022344620 A1 | 27-10-2022 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20220190845